# EUROPEAN PATENT SPECIFICATION

(11) **EP 1 654 298 B1**
(45) Date of publication and mention of the grant of the patent: **01.10.2008**
(21) Application number: 04763557.8
(22) Date of filing: 28.07.2004
(51) Int. Cl.: C08G 61/12, H01B 1/12

(54) **PROCESS OF PREPARING REGIOREGULAR POLYMERS**
VERFAHREN ZUR HERSTELLUNG VON REGIOREGULÄREN POLYMEREN
PROCEDE DE PREPARATION DE POLYMERES REGIOREGULIERS

(30) Priority: 06.08.2003 EP 03017920; 08.08.2003 US 493451 P
(43) Date of publication of application: 10.05.2006
(73) Proprietor: Merck Patent GmbH, 64293 Darmstadt (DE)
(72) Inventor: Koller, Guntram, 64823 Goss-Umstadt (DE); Falk, Birgit, 64560 Riedstadt (DE); Weller, Clarissa, 64285 Darmstadt (DE); Giles, Mark, Bitterne Park, Southampton SO18 1UH (GB); MCculloch, Iain, Chandlers Ford, Southampton S053 4LG (GB)
(86) International application number: PCT/EP2004/008438
(87) International publication number: WO 2005/014691

(56) References cited:
- EP-A- 1 028 136
- EP-A- 1 398 336
- US-A- 4 521 589
- US-A- 5 756 653
- US-A1- 2003 062 509
- US-B1- 6 602 974
- TAKAKAZU YAMAMOTO: "Preparation and Characterization of Polythienylenes" BULL. CHEM. SOC. JPN., vol. 56, - 1983 pages 1497-1502,
- GUNNAR ENGELMANN: "Sudies of beta-methylated end-capped bithiophenes" J. CHEM. SOC. PERKIN TRANS. 2, 1998, pages 169-175,
- HIROYUKI HIGUCHI: "Synthesis and Properties of ...." BULL. CHEM. SOC. JPN., vol. 74, 2001, pages 889-906,

## Description

### Field of Invention

The invention relates to a process of preparing regioregular polymers, in particular head-to-tail (HT) poly-(3-substituted) thiophenes with high regioregularity, and to novel polymers prepared by this process. The invention further relates to the use of the novel polymers as semiconductors or charge transport materials in optical, electrooptical or electronic devices including field effect transistors (FETs), electroluminescent, photovoltaic and sensor devices. The invention further relates to FETs and other semiconducting components or materials comprising the novel polymers. The invention further relates to a process of endcapping polymers, to polymers obtained by this process, and to their use in the above devices.

### Background and Prior Art

Organic materials have recently shown promise as the active layer in organic based thin film transistors and organic field effect transistors (OFETs) [see H. E. Katz, Z. Bao and S. L. Gilat, Acc. Chem. Res., 2001, 34, 5, 359]. Such devices have potential applications in smart cards, security tags and the switching element in flat panel displays. Organic materials are envisaged to have substantial cost advantages over their silicon analogues if they can be deposited from solution, as this enables a fast, large-area fabrication route.

The performance of the device is principally based upon the charge carrier mobility of the semiconducting material and the current on/off ratio, so the ideal semiconductor should have a low conductivity in the off state, combined with a high charge carrier mobility (> 1 x 10⁻³ cm² V⁻¹ s⁻¹). In addition, it is important that the semiconducting material is relatively stable to oxidation i.e. it has a high ionisation potential, as oxidation leads to reduced device performance.

In prior art regioregular head-to-tail (HT) poly-(3-alkylthiophene), in particular poly-(3-hexylthiophene), has been suggested for use as semiconducting material, as it shows charge carrier mobility between 1 x 10⁻⁵ and 0.1 cm² V⁻¹ s⁻¹. Also, poly-(3-alkylthiophene) shows good solubility in organic solvents and is solution processable to fabricate large area films.

A high regioregularity of the poly-(3-alkylthiophene) is important for its electronic and photonic properties, as it leads to improved packing and optimised microstructure, leading to improved charge carrier mobility [see US 6,166,172, H. Sirringhaus et al., Science, 1998, 280, 1741-1744; H. Sirringhaus et al., Nature, 1999, 401, 685-688; and H. Sirringhaus, et al., Synthetic Metals, 2000, 111-112, 129-132]. The regioregularity is strongly influenced by the method of preparing the polymer.

Several methods to produce highly regioregular HT-poly-(3-alkylthiophene) have been reported in prior art, for example in the review of R.D. McCullough, Adv. Mater.,1998, 10(2), 93-116 and the references cited therein.

Known methods to prepare HT-poly(3-alkylthiophene) with a regioregularity ≥ 90 % starting from 2,5,dibromo-3-alkylthiophene include for example the "Rieke method", by reacting the educt (wherein R is alkyl) with highly reactive zinc in THF as illustrated below.

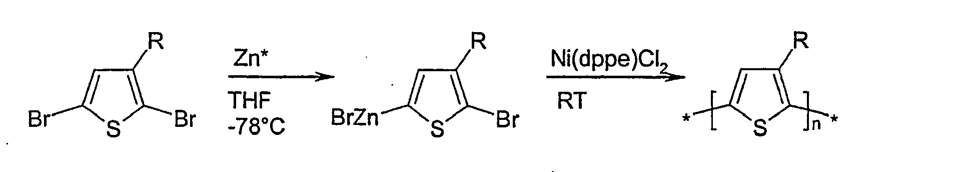

Also known is the method described in McCullough et al., Adv. Mater.,1999, 11(3), 250-253 and in EP 1 028 136 and US 6,166,172, the entire disclosure of these documents being incorporated into this application by reference. According to this route the educt is reacted with methylmagnesium bromide in THF as shown below.

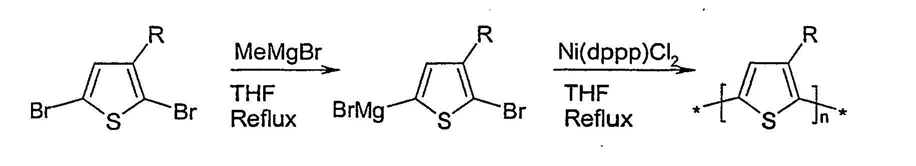

It was also reported to prepare regioregular poly(3-alkylthiophene) by the "Stille-method" (see Stille, Iraqi, Barker et al., J. Mater. Chem., 1998, 8, 25) as illustrated below 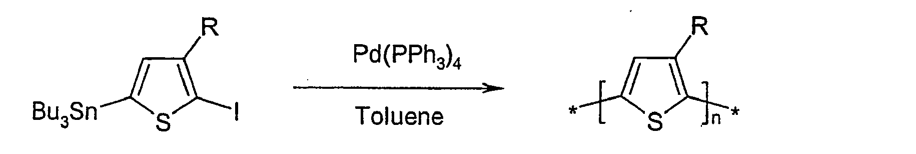 or by the "Suzuki-method" (see Suzuki, Guillerez, Bidan et al., Synth. Met., 1998, 93, 123) as shown below.

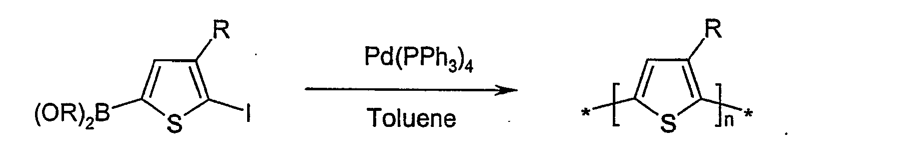

However, the methods described in prior art have several drawbacks. Thus, for example the Rieke method requires the costly and difficult preparation of the highly active "Rieke zinc". The Stille and Suzuki methods require an extra processing step which reduces the process efficiency. The McCullough method requires the costly Grignard reagent methylmagnesium bromide. Additionally, it produces methyl bromide as a by-product in stoichiometrical quantities which especially in large scale production causes environmental problems. As methyl bromide cannot be eliminated from the exhaust gases with a gas washer, costly techniques and means for exhaust air combustion are needed.

Prior art also reports the preparation of unsubstituted polythiophene by Nickel-catalysed coupling of a Grignard reagent that is formed from the reaction of a 2,5-dihalogenated thiophene with magnesium. This route was first reported in 1984 (J. P. Montheard; T. Pascal, Synth. Met, 1984, 9, 389 and M. Kobayashi; J. Chen; T.-C. Chung; F. Moraes; A. J. Heeger; F. Wudl, Synth. Met, 1984, 9, 77). However, this method yielded only low molecular weights. Also these polymers only have low solubility, compared to 3-alkyl substituted polythiophenes.

There are also reports on the preparation of poly (3-alkyl thiophene) using the Nickel-catalysed coupling of a Grignard reagent formed from 2,5-dihalogenated 3-alkylthiophene with magnesium as illustrated below.

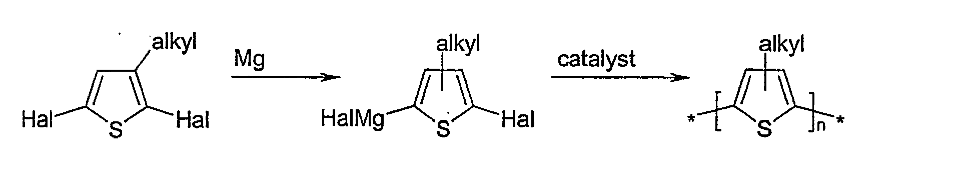

T. Yamamoto; K.-I. Sanechika; A. Yamamoto, Bull. Chem. Soc. Jpn., 1983, 56, 1497 and US 4,521,589 describe the Grignard coupling of 2,5-dihalo-3-alkylthiophene in THF, wherein the alkyl group is lower alkyl with 1 to 4 C-atoms, like methyl. However, the resulting polymers are reported to have low molecular weight (1,370 or 2,300) and low regioregularity (as can be seen from the ¹H-NMR spectra). US 4,521,589 also mentions a higher weight fraction with a degree of polymerization of 96 as concluded from IR spectra, but no molecular weight measurement data are given. A series of publications by Elsenbaumer et al. also describes the synthesis of poly (3-alkyl thiophenes) by Grignard coupling (R. L. Elsenbaumer; K. Y. Jen; R. Oboodi, Synth. Met, 1986, 15, 169; furthermore K. Y. Jen; R. Oboodi; R. L. Elsenbaumer, Polym. Mater. Sci. Eng., 1985, 53, 79 and K.-Y. Jen; G. G. Miller; R. L. Elsenbaumer, J Chem Soc, Chem Commun, 1986, 1346). However, these polymers mostly have molecular weights (Mₙ) in the range of 3,000 to 8,000, with the exception of a homopolymer obtained from 2,5-diiodo-3,4-dimethylthiophene and a copolymer obtained from 2,5-diiodo-3-methyl- and 2,5-diiodo-3-n-butylthiophene, which are reported to have a molecular weight of 26,000 and 35,000 respectively. US 4,711,742 (Elsenbaumer et al.) reports the synthesis of poly(3-butylthiophene) by Grignard coupling of the diiodo monomer in 2-methyl-tetrahydrofuran, giving a molecular weight of 41,400 corresponding to a degree of polymerization of 300. However, the poly (3-alkyl thiophenes) described in the above documents are regiorandom with relatively low amounts of the desired head-to-tail head-to-tail (HT-HT) triads (see e.g. K.-Y. Jen; G. G. Miller; R. L. Elsenbaumer, J Chem Soc, Chem Commun, 1986, 1346).

In a study of poly (3-decyl thiophene) made by three different routes (see P. C. Stein; C. Botta; A. Bolognesi; M. Catellani, Synth. Met, 1995, 69, 305) a sample prepared using the Grignard polymerisation of the diiodo monomer was found to have a regioregularity of 70% by ¹H-NMR. A study of the synthesis of poly (3-hexyl thiophene) using the Grignard reaction of 2,5-diiodo-3-hexylthiophene with magnesium in ether (see H. Mao; S. Holdcroft, Macromolecules, 1992, 25, 554) resulted in a molecular weight (Mₙ) of 5,200. No direct regioregularity data are given but the ¹H-NMR shows peaks from all four possible triads, suggesting relatively low regioregularity. Another study of the same authors (see H. Mao; S. Holdcroft, Macromolecules, 1993, 26, 1163) reported only poly (3-hexyl thiophenes) with low regioregularities (up to 58 % HT-HT triads or up to 80 % HT dyads).

In conclusion, although the preparation of poly (3-alkyl thiophenes) by Grignard reaction with magnesium has been described in the literature, the polymers synthesised are reported to have low molecular weight and/or low or random regioregularity.

Therefore, there is still a need for an improved method of preparing polymers, in particular poly-(3-substituted) thiophenes with high regioregularity, high molecular weight, high purity and high yields in an economical, effective and environmentally beneficial way, which is especially suitable for industrial large scale production.

It was an aim of the present invention to provide an improved process for preparing polymers with these advantages, but not having the drawbacks of prior art methods mentioned above.

Other aims of the present invention are immediately evident to the person skilled in the art from the following detailed description.

The inventors of the present invention have found that these aims can be achieved, and the above problems be solved, by providing a process of preparing polymers, in particular poly-(3-substituted) thiophenes according to the present invention as described below. According to this process, a 3-substituted thiophene monomer with at least two groups, wherein these groups are leaving groups that are capable of reacting with magnesium, is reacted with magnesium in a suitable solvent to form an intermediate, which is then polymerized in the presence of a suitable catalyst. It was surprisingly found that, by chosing appropriate reagents and reaction conditions, it is possible to obtain polymers, in particular poly-(3-substituted) thiophenes, with high regioregularity, high molecular weight and high purity in good yields and avoiding large amounts of hazardous by-products that need to be eliminated.

The polymers prepared by the process according to the present invention are especially useful as charge transport materials for semiconductor or light-emitting materials, components or devices.

The above described routes of preparing polymers usually give a polymer that is terminated by reactive groups such as halogens, organometallic species such as boronate esters or trialkyl tins, or very reactive groups such as organo-magnesium or organo-zincs, which will be quenched under standard work up procedures. However, these groups have a disadvantageous effect on the electrical properties of the polymer; for example in semiconducting applications they can trap charges and thus reduce the charge carrier mobility of the polymer. It is therefore a further aim of this invention to further improve the electrical properties of the polymers obtained by the inventive process and also by the prior art methods as described above. The inventors have found that this aim can be achieved by chemical modification ('endcapping') of the polymers as described above and below. Thus, replacing the end groups of the polymers for example with alkyl groups or hydrogen can give poly (3-alkylthiophenes) with improved electrical properties. Another aspect of the invention therefore relates to a process of endcapping polymers, in particular regioregular poly (3-alkyl thiophenes) and to polymers obtained by this process.

EP-A-1 398 336; US 2003/062509 A1; US 6,602,974 B1; US 5,756,653 A1; T. Yamamoto et al., Bull. Chem. Soc. Jpn. 1983, 56, 1497-1502; G. Engelmann et al., J. Chem. Soc. Perkin Trans. 1998, 2, 169-175 and H. Higuchi et al., Bull. Chem. Soc. Jpn. 2001, 74, 889-906 disclose methods of preparing 3-substituted bi- or polythiophenes, but do not disclose a process according to the present invention.

### Summary of the Invention

The invention relates to a process of preparing a regioregular poly (3-substituted thiophene) by providing a 3-substituted thiophene having chloro and/or bromo groups in 2- and 5-position, reacting said thiophene with magnesium in a solvent selected from the group consisting of linear ethers, mixtures thereof, and mixtures of toluene with one or more linear ethers, and polymerising the formed regiochemical Grignard intermediate or mixture of regiochemical Grignard intermediates by adding a suitable catalyst.

The invention further relates to a process as described above and below, wherein the polymer is a regioregular head-to-tail (HT) polymer having a regioregularity of ≥ 90 %, preferably ≥ 95 %, very preferably ≥ 98 %.

The invention further relates to a process as described above and below, by
a) dissolving the 3-substituted thiophene in a solvent or a mixture of solvents selected from the group consisting of linear ethers, mixtures thereof, and mixtures of toluene with one or more linear ethers,
b) adding magnesium in an at least molar amount of the thiophene to the solution, or adding the solution to said magnesium, wherein said magnesium reacts with the thiophene to form a regiochemical Grignard intermediate or a mixture of regiochemical Grignard intermediates,
c) optionally removing the unreacted magnesium from the reaction mixture,
d) adding a catalyst to the reaction mixture, or adding the reaction mixture to a catalyst, and optionally agitating the resulting mixture, to form a polymer, and
e) recovering the polymer from the mixture.

The invention further relates to a process as described above and below, wherein one or more of the terminal groups of the polymer are chemically modified ('endcapped'). The invention further relates to a process of chemically modifying the terminal group of a polymer, in particular of a poly-3-substituted thiophene, during or after polymerisation ('endcapping').

The invention further relates to a polymer obtainable by a process of endcapping as described above and below, which is of formula I2 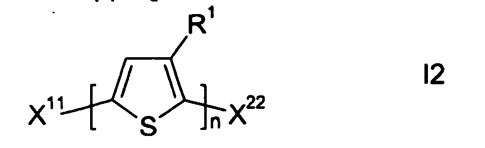 wherein
R¹ is straight-chain, branched or cyclic alkyl with 1 to 20 C-atoms,
n is from 10 to 5,000,
X¹¹ and X²² are selected from alkyl that is optionally substituted with one or more fluorine atoms, alkenyl, alkynyl, alkoxy, thioalkyl, silyl, or fluoroalkyl, all of these groups being straight-chain or branched and having 1 to 20 C atoms, optionally substituted aryl or heteroaryl, or P-Sp,
P is selected from CH₂=CH-COO-, CH₂=C(CH₃)-COO-, CH₂=CH-, CH₂=CH-O-, (CH₂=CH)₂CH-OCO-, (CH₂=CH)₂CH-O-, 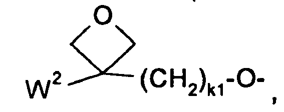 or protected derivatives thereof,
W² is H or alkyl with 1 to 5 C-atoms, in particular methyl, ethyl or n-propyl, k₁ is 0 or 1, and
Sp is a spacer group or a single bond.

The invention further relates to a semiconductor or charge transport material, component or device comprising one or more polymers as described above and below.

The invention further relates to the use of polymers according to the invention as semiconductors or charge transport materials, in particular in optical, electrooptical or electronic devices, like for example in field effect transistors (FET) as components of integrated circuitry, as thin film transistors in flat panel display applications or for Radio Frequency Identification (RFID) tags, or in semiconducting components for organic light emitting diode (OLED) applications such as electroluminescent displays or backlights of e.g. liquid crystal displays (LCD), for photovoltaic or sensor devices, as electrode materials in batteries, as photoconductors and for electrophotographic applications like electrophotographic recording.

The invention further relates to the use of the polymers according to the present invention as electroluminescent materials, in photovoltaic or sensor devices, as electrode materials in batteries, as photoconductors, for electrophotographic applications or electrophotographic recording or for detecting and discriminating DNA sequences.

The invention further relates to an optical, electrooptical or electronic device, FET, integrated circuit (IC), TFT or OLED comprising a semiconducting or charge transport material, component or device according to the invention.

The invention further relates to a TFT or TFT array for flat panel displays, radio frequency identification (RFID) tag, electroluminescent display or backlight comprising a semiconducting or charge transport material, component or device or a FET, IC, TFT or OLED according to the invention.

The invention further relates to a security marking or device comprising a FET or an RFID tag according to the invention.

### Brief Description of the Drawings

**Figures 1** shows forward transfer characteristics for polymers with different endgroups according to example 1 and 2 of the present invention.
**Figure 2** shows repeated forward transfer scans for polymers with different endgroups according to example 1 and 2 of the present invention.
**Figure 3** shows transistor output characteristics at low V_{sd} for polymers with different endgroups according to example 1 and 2 of the present invention.

### Detailed Description of the Invention

The polymers prepared by the process according to the present invention are preferably selected of formula I 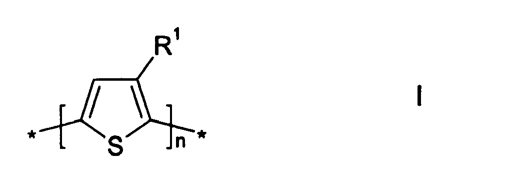 wherein n is an integer > 1 and R¹ is a group that does not react with magnesium under the conditions as described for the process according to the present invention above and below. Preferably R¹ is an organic group which when it is unsubstituted and unmodified straight chained or branched alkyl has 5 or more C-atoms. Very preferably R¹ is an organic group having 5 or more C-atoms.

The thiophene used as educt in the process according to the present invention is preferably selected of formula II 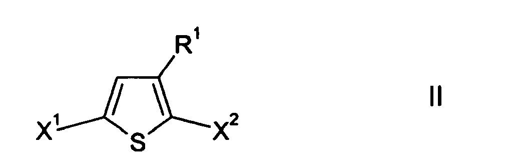 wherein R¹ has the meaning given in formula I and X¹ and X² are Cl and/or Br, most preferably Br.

The process according to the present invention offers significant advantages over the methods disclosed in prior art especially regarding economical and ecological aspects, whilst providing polythiophenes in comparable or even better yield and quality.

With the process according to the present invention it is possible to prepare polythiophenes, in particular HT-poly-(3-substituted) thiophenes with a regioregularity of 90 % or higher in a yield of 50 % or higher (related to the thiophene educt). As mentioned above, these highly regioregular HT-poly-(3-substituted) thiophenes are particularly suitable for use as charge-transport or semiconductor material in electronic or optical devices.

The regioregular polymers of the present invention thus have a high number, and do preferably exclusively consist, of HT-linked repeating units as shown in formula Ia

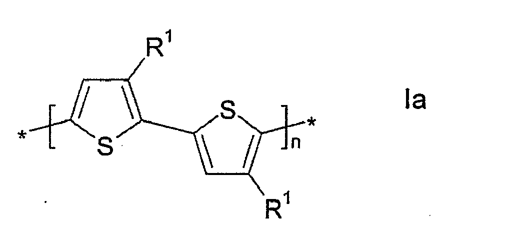

Furthermore, the costly and difficult preparation of Grignard reagents like organomagnesium halides is not necessary, instead magnesium can be used as reagent. Also, the emission of large amounts of hazardous by-products like methyl bromide can be avoided.

The general method of adding magnesium instead of Grignard reagents like organomagnesium halides has been described in prior art for the preparation of polythiophenes and poly-3-alkylthiophenes. However, magnesium is generally not considered to be highly regioselective in conventional Grignard reactions. This is supported by the teaching of the prior art documents mentioned above, which do not report polymers with high regioregularity.

The inventors of the present invention have found that polythiophenes with high regioregularity, high molecular weight and good processability can be obtained by appropriate selection of the reaction conditions and the reagents, like the use of linear ethers as solvents and of thiophene monomers with bromo or chloro groups in 2/5-position as educts. Also, the use of 3-substituted thiophenes with organic substituents in 3-position that preferably have 5, 6 or more C-atoms improves the processability and solubility of the polythiophene. As a result, during polymerisation the growing polymer remains longer in solution and a high molecular weight and good regioregularity can be obtained.

After polymerisation the polymer is preferably recovered from the reaction mixture, for example by conventional work-up, and purified. This can be achieved according to standard methods known to the expert and described in the literature.

As a result of the process according to the present invention, the obtained polythiophenes are usually terminated by the leaving groups that are capable of reacting with magnesium in 2 and 5-position of the thiophene monomer, or derivatives thereof. In case thiophene educts of formula II are used, the obtained polymers correspond to formula 11 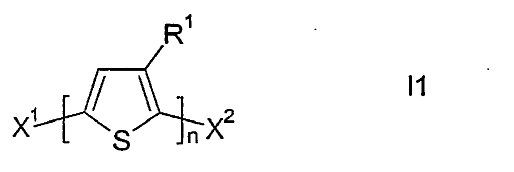 wherein n, R¹, X¹ and X² have the meanings given in formula I and II.

Another object of the present invention is a process of chemically modifying the reactive terminal groups of a polymer, in particular a poly-3-substituted thiophene, during or after polymerisation. This process is hereinafter also referred to as 'endcapping'. Another object of the invention is a polymer, in particular a poly-3-substituted thiophene, wherein the terminal groups are chemically modified to replace monomer end groups, hereinafter also referred to as 'endcapped polymer'. Another object of the invention is the use of an endcapped polymer, in particular an endcapped poly-3-substituted thiophene, as semiconductor or charge transport material, in particular for the uses and devices as described above and below.

Endcapping of polyalkylthiophene is known in the art and is described for example by B. M. W. Langeveld-Voss, R. A. J. Janssen et al., Chem Commun 2000 81-82, and J. Liu., R. S. Loewe and R. D. McCullough, Macromolecules, 1999, 32 5777-5785, as an aid for understanding the reaction mechanism (Liu, Janssen) or to enable a later reaction of the polymer or to encourage binding to a substrate (Janssen). Furthermore, US 6,602,974 describes the chemical modification of polyalkylthiophenes by replacing the terminal halogen groups with H or functional end groups for the preparation of block copolymers.

The inventors of the present invention have found that endcapping can also be used as a suitable method to provide a polymer with improved electrical properties. For example, by removing bromine end groups from the polymer chains, a source of charge carrier trapping is eliminated and higher charge carrier mobilities can be observed. The main benefit concerns the improvement in transistor performance stability. The carbon - bromine bond is susceptible to undergo further reaction in the presence of charged species, which are present during transistor operation. These suspected chemical reactions both change the properties of the semiconducting polymer, as well as release mobile ions, which lead to transistor hysteresis and threshold voltage drifts. Endcapping reduces the reactivity of the charged polymer and hence improves stability.

Thus, another aspect of the invention relates to a method of improving the electrical properties, like the charge carrier mobility, and the processability, of a polymer, in particular of a polyalkylthiophene, by chemically modifying the endgroups of the polymer (endcapping) as described above and below. Another aspect of the invention relates to endcapped polymers and their use as semiconductors, for example in the applications as described above and below.

The process of endcapping by conversion of, for example, residual halogen end groups into other groups or reactive species is not limited to polymers obtained by the method of the present invention. It can also be carried out with other polymers, for example those obtained by the methods of Rieke, McCullough, Suzuki or Stille as described above.

Endcapping can be carried out before or after recovering the polymer from the polymerisation reaction mixture, before or after work-up of the polymer or before or after its purification, depending on which is more suitable and more effective regarding the material costs, time and reaction conditions involved. For example, in case expensive co-reactants are used for endcapping it may be more economical to carry out the endcapping after purification of the polymer. In case the purification effort is economically more important than the co-reactants it may be preferred to carry out the endcapping before purification or even before recovering the polymer from the polymerisation reaction mixture.

Especially preferred are endcapped poly-3-substituted thiophenes obtained by a Grignard reaction with magnesium according to the inventive process as described above and below, wherein the reactive terminal groups of the polymer are chemically modified during or after polymerisation, or after recovering the polymer from the mixture, or after purification of the polymer.

As a result of the process according to the present invention, at the end of the polymerisation step the end groups X¹ and X² are either a halogen or Grignard group. At this stage, an aliphatic Grignard reagent RMgX or dialkyl Grignard reagent MgR₂, wherein X is halogen and R is an aliphatic group, or active Magnesium is preferably added to convert the remaining halogen end groups to Grignard groups. Subsequently, for example to give an alkyl end group an excess of an ω-haloalkane is added which will couple to the Grignard. Alternatively, to give a proton end group the polymerisation is quenched into a non-solvent such as an alcohol.

To provide reactive functional end groups, like for example hydroxyl or amine groups or protected versions thereof, the halogen end groups are for example reacted with a Grignard reagent R'MgX, wherein R' is such a reactive functional group or protected reactive functional group.

Instead of a Grignard reagent it is also possible to carry out endcapping using an organo lithium reagent, followed by addition of an ω-haloalkane.

It is also possible to replace H end groups by reactive functional groups by using e.g. the methods described in US 6,602,974, such as a Vilsmeier reaction to introduce aldehyde groups followed by reduction with metal hydrides to form hydroxyl groups.

If the polymer has been fully worked up prior to endcapping, it is preferred to dissolve the polymer in a good solvent for Grignard coupling such as diethyl ether or THF. The solution is then treated for example with the above mentioned organo Grignard reagent RMgX or MgR₂ or R'MgX or with a zinc reagent, RZnX, R'ZnX or ZnR₂, where R and R' are as defined above. A suitable nickel or palladium catalyst is then added along with the haloalkane.

This method of endcapping is also effective for example for polymers prepared by the McCullough or Rieke route.

In the case of polymers prepared by the Suzuki or Stille route, these are preferably endcapped as follows: For the Suzuki reaction at the end of the polymerisation alkyl termination is preferably obtained by addition of a 2-boronic-5-alkyl thiophene to react with the bromine end groups, followed by an excess of a 2-bromo-5-alkyl thiophene to react with the boronic end groups. To obtain a hydrogen endcapped species, reaction with 2-boronic thiophene followed by an excess of 2-bromo thiophene is required. A similar process can be employed for the Stille route, but using a 2-trialkyl stannyl reagent, for example 2-trialkyl stannyl-5-alkyl thiophene, instead of boronic thiophene. Similarly, if the endcapping is carried out after initial quenching and purification of the polymer, it is preferred to dissolve the polymer and add a suitable catalyst.

Very preferred are endcapped polymers wherein the terminal groups during or after polymerisation are replaced by H or an alkyl group (hereinafter also referred to as 'polymers endcapped by H or an alkyl group').

Preferably endcapping is carried out before purification of the polymer. Further preferably endcapping is carried out after step d) of the process as described above and below. In another preferred embodiment of the present invention the endcapper is added during polymerisation to remove the end groups and possibly control the molecular weight of the polymer.

Preferably, substantially all molecules in a polymer sample are endcapped in accordance with this invention, but at least 80 %, preferably at least 90 %, most preferably at least 98 % are endcapped.

By chemical modification of the terminal groups (endcapping) of the polymers according to the present invention, it is possible to prepare novel polymers with different terminal groups. These polymers are preferably selected of formula I2 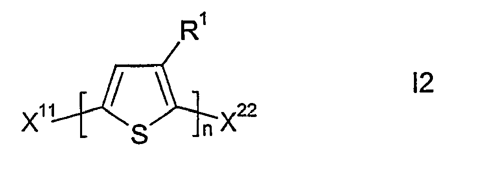 wherein n and R¹ have the meanings given in formula I and II, and X¹¹ and X²² are independently of each other H, halogen, stannate, boronate or an aliphatic, cycloaliphatic or aromatic group that may also comprise one or more hetero atoms.

Especially preferably X¹¹ and X²² are selected from H or straight-chain or branched alkyl with 1 to 20, preferably 1 to 12, very preferably 1 to 6 C-atoms, most preferably straight-chain alkyl or branched alkyl like isopropyl or tert. butyl. Aromatic groups X¹¹ and X²² tend to be bulky and are less preferred.

As described above, the end groups X¹¹ and X²² are preferably introduced by reacting the polymer of formula I1 with a Grignard reagent MgRX, MgR₂ or MgR'X as described above, wherein R and R' are X¹¹ or X²² as defined in formula 12.

By introducing suitable functional end groups X¹¹ and/or X²² it is possible to prepare block copolymers from the polymers according to the present invention. For example, if one or both of the end groups X¹¹ and X²² in a polymer of formula I2 is a reactive group or a protected reactive group, like for example an optionally protected hydroxy or amine group, they can be reacted (after removing the protective group) with the end group of another polymer of formula I2 (e.g. with different groups R¹ and/or X¹¹ and/or X22), or with a polymer of different structure. If one of X¹¹ and X²² is a reactive group, diblock copolymers can be formed. If both X¹¹ and X²² are reactive groups, a triblock copolymer can be formed.

Alternatively a block copolymer can be formed by introducing reactive or protected reactive groups X¹¹ and/or X²², adding a catalyst and one or monomers, and initiating a new polymerization reaction starting from the site of the groups X¹¹ and/or X²².

Suitable functional end groups and methods of their introduction can be taken from the above disclosure and from prior art. Details how to prepare block copolymers can be taken e.g. from US 6,602,974, the entire disclosure of which is incorporated into this application by reference.

The process according to the present invention is exemplarily illustrated in Scheme 1 below, wherein n, R¹, X¹ and X² have the meaning of formula I and II.

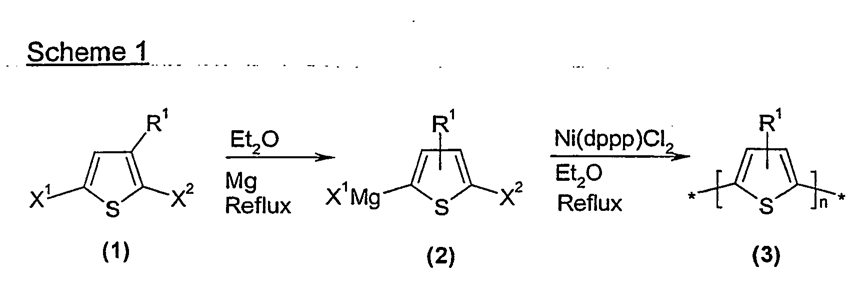

If R¹ is a group that is reactive with magnesium under the process conditions as described above and below, it is preferably transformed into, or coupled with, a protective group, in order not to take part in the reactions forming (**2**) and (**3**). Suitable protective groups are known to the expert and described in the literature, for example in Greene and Greene, "Protective Groups in Organic Synthesis", John Wiley and Sons, New York (1981).

The starting materials and reagents used in the process according to the present invention are either commercially available (e.g. from Aldrich) or can be easily synthesized by methods well known to those skilled in the art.

In some cases it may be suitable to further purify the thiophene monomer and the other reagents before using them in the inventive process. Purification can be carried out by standard methods known to the expert and described in the literature.

The process according to the present invention as exemplarily depicted in Scheme 1 is preferably carried out as follows:

In a first step (step a)) a 3-substituted thiophene (1), which is a 3-substituted 2,5-dihalothiophene, most preferably 3-substituted 2,5-dibromothiophene, like for example 2,5-dibromo-3-alkylthiophene, which is a readily available starting material, is dissolved in a solvent or a solvent mixture, like for example diethyl ether.

Preferably the solvent is selected from linear ethers like diethyl ether, di-n-butyl ether, di-n-propyl ether, di-isopropyl ether, glycol ethers such as 1,2-dimethoxyethane, ethers with two different alkyl groups such as tert.-butylmethyl ether or mixtures thereof, or a mixture of toluene with one or more of these ethers.

Especially preferably the solvent is diethyl ether.

The concentration of the thiophene educt (**1**) in the solvent is preferably from 40 to 200 g/l, very preferably from 80 to 130 g/l.

In a second step (step b)) magnesium is added to the reaction mixture in an at least molar amount of the thiophene educt (**1**), preferably in an excessive amount from more than 1 to 3, preferably from 1.01 to 2.00, very preferably from 1.02 to 1.50, most preferably from 1.02 to 1.20 times the molar amount of the thiophene educt.

The Grignard reaction is then started for example by heating the reaction mixture to reflux or by adding a suitable starting agent such as Br₂, I₂, DIBAH (diisobutylaluminium hydride) or others, or by other methods of activating the magnesium surface. The Grignard reaction is then allowed to proceed, optionally under agitating and/or heating the reaction mixture, for a sufficient period of time to give the intermediate (**2**).

In an optional next step (step c)), the non-reacted magnesium is then removed from the reaction mixture e.g. by filtration. Preferably the magnesium is removed.

In the next step (step d)), a suitable catalyst is added to the reaction mixture in an effective amount to initiate the polymerisation via a Grignard metathesis reaction. Usually the catalyst is reactive enough to start the polymerisation without other means, however in practice the mixture is typically stirred while adding the catalyst.

Alternatively, it is possible to add the reaction mixture to the catalyst.

The catalyst in step d) can be any catalyst that is suitable for a reaction involving organometallic reagents, including for example Ni, Pd or other transition metal catalysts. Preferably it is selected from nickel catalysts, in particular Ni(II) catalysts like Ni(dppp)Cl₂ (1,3-diphenylphosphinopropane nickel(II) chloride) or Ni(dppe)Cl₂ (1,2-bis(diphenylphosphino)ethane nickel(II) chloride), furthermore e.g. copper catalysts like Cul, CuBr or Li₂CuCl₄ or Pd catalysts like Pd(PPh₃), PdCl₂(dppe).

The catalyst is preferably added in an amount from 0.1 to 5 %, preferably 0.5 to 2 mol % of the thiophene educt.

The polymerisation (Grignard metathesis) reaction is then allowed to proceed, optionally under agitating and/or heating the reaction mixture, for a sufficient period of time to give the polymer (**3**).

The process according to the present invention may be run at any temperature providing a sufficient conversion rate. It is preferred that the reaction is performed at a temperature between -5°C and the solvent's reflux temperature, in particular at the temperatures as specified above and below. The term "reflux temperature" includes temperatures at or slightly below the boiling point of the solvent.

The selection of a suitable reaction time depends on the actual rate of the individual reaction. Preferably the reaction times are as given above and below.

For the reaction of the thiophene educt with magnesium (step b)) the reaction temperature is preferably in the range from 10 °C to reflux temperature, most preferably from room temperature to reflux temperature. The reaction time is from 15 min to 24 h, preferably from 30 min to 6 h.

For the polymerisation reaction (step d)) the temperature is preferably in the range from -5 °C to reflux temperature, most preferably from room temperature to reflux temperature. The reaction time is from 15 min to 48 h, preferably from 45 min to 4h.

The reactions according to steps b) and d) are optionally carried out under agitating the reaction mixture,which can be achieved by known methods.

Steps a) to d), in particular steps b) and d) are preferably carried out under a dry and inert atmosphere, e.g. under nitrogen.

The reaction products (**2**) and (**3**) prepared by the process according to the present invention may be isolated by usual work-up and purification with standard procedures well known to those skilled in the art.

The intermediate (**2**) obtained in step b) is directly used in step d). However, for the purpose of e.g. investigating the proceeding of the reaction process or analysing the ratio of the regiochemical intermediates produced it may be suitable to quench the reaction mixture.

In the last step (step e)) the polymer (**3**) is recovered from the reaction mixture. Preferably the polymer is recovered from the mixture by quenching the reaction mixture with an alcoholic or aqueous solution or/and precipitating the polymer.

The polymer can then be purified by known methods to remove inorganic impurities as well as monomers and short-chain oligomers, or may also be used without further purification. Preferably the polymer is purified. Suitable and preferred purification methods include solid-phase extraction, liquid-liquid extraction, precipitation, adsorption and filtration. Preferably a combination of purification methods is selected to obtain a high-purity product best suitable for application,

For example a preferred purification method includes aqueous quenching, for example with a mixture of chloroform/water, optional liquid/liquid extraction or distilling off the original solvent, precipitation into a polar solvent like for example methanol, and washing with an unpolar solvent like for example heptane.

Suitable reagents and process conditions for the steps d) and e) including the reaction of the intermediate (**2**) to the polymer (**3**), can also be taken from McCullough et al., Adv. Mater., 1999, 11(3), 250-253, EP 1 028 136 and US 6,166,172, the entire disclosure of these documents being incorporated into this application by reference.

An especially preferred embodiment relates to a process including the following steps
a) dissolving a thiophene of formula II, very preferably in an amount of from 40 to 200 g/l, in diethyl ether,
b) adding magnesium in 1.02 to 1.20 times the molar amount of the thiophene, or adding the thiophene solution to the magnesium, and heating the mixture to reflux to form a regiochemical Grignard intermediate,
c) removing the unreacted magnesium from the reaction mixture,
d) adding a Ni(II) catalyst, preferably Ni(DPPP)Cl₂ or Ni(DPPE)Cl₂ to the reaction mixture, or adding the reaction mixture to the Ni(II) catalyst, and agitating the resulting mixture, preferably under reflux, to form a polymer, and
e) recovering the polymer from the mixture.

The intermediate (**2**) is usually obtained as a mixture of regiochemical isomers (**2a**) and (**2b**), and may also include a, typically small, amount of the double-Grignard product (**2c**), as shown below, wherein X¹, X² and R¹ have the meanings of formula I and I1

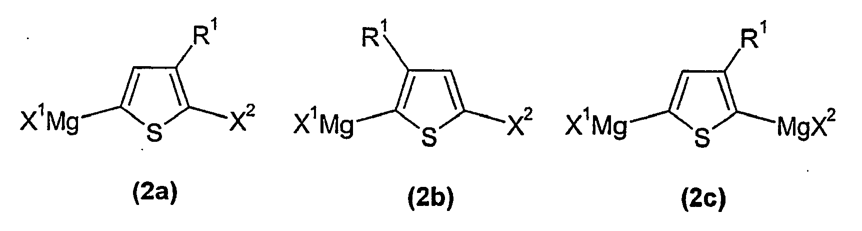

The ratio of these intermediates is depending for example on the molar excess of Magnesium, the solvent, temperature and reaction time.

For example, if the reaction is carried out according to the especially preferred embodiment described above, the intermediates 2a, 2b and 2c can be obtained in a ratio of 85/5/10.

Depending on the processing conditions, like for example the solvent and the amount of magnesium, the ratio of isomer intermediates 2a/2b/2c can be varied. A preferred process includes isomer intermediate ratios 2a/2b/2c of 80-90/2-20/0-20.

The polymers according to the present invention are especially preferably regioregular HT-poly-(3-substituted) thiophenes. The regioregularity (=head-to-tail couplings divided by the total couplings, and expressed as a percentage), in these polymers is preferably at least 85 %, in particular 90% or more, very preferably 95% or more, most preferably from 98 to 100%.

Polymers of formula I, I1 and I2 having a high percentage of HT-couplings accordingly have a corresponding high number of HT dyads or HT-HT-triads formula Ia/b, I1a/b and I2a/b shown below. 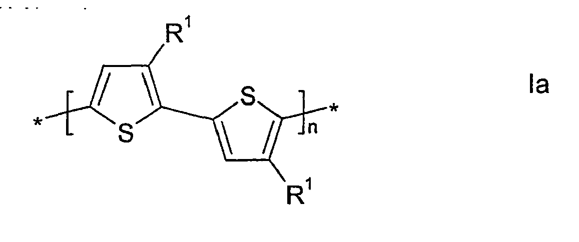 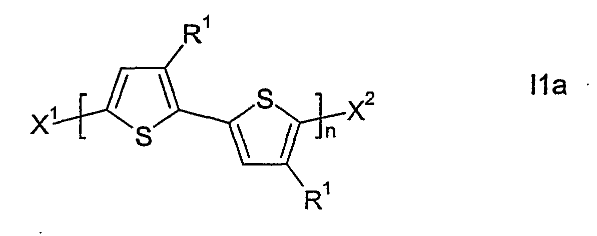 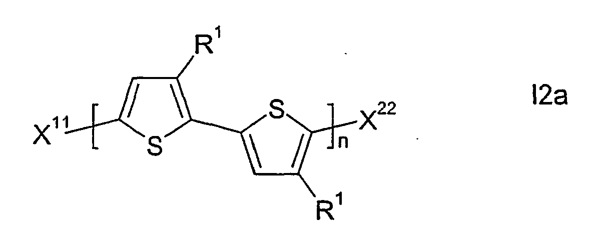 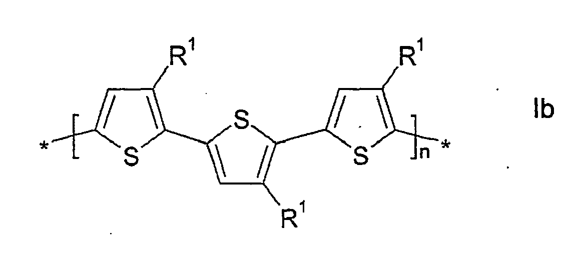 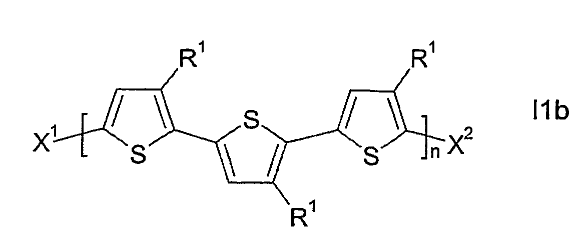 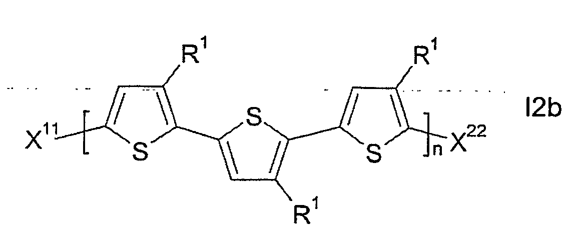 wherein R¹, X¹, X², X¹¹, X²² have the meanings given above.

Regioregular poly-(3-substituted) thiophenes are advantageous as they show strong interchain pi-pi-stacking interactions and a high degree of crystallinity, making them effective charge transport materials with high carrier mobilities, as described for example in US 6,166,172.

The polymers according to the present invention preferably have a degree of polymerisation (or number n of recurring units) from 2 to 5,000, in particular from 10 to 5,000 or from 110 to 5,000, very preferably from 50 to 1,000, most preferably from above 100 to 1,000.

Further preferred are polymers having a molecular weight from 5,000 to 300,000, in particular from 10,000 to 100,000, preferably from 15,000 to 100,000, very preferably from 20,000 to 100,000.

R¹ in formula I, I1 and II is preferably an organic group, preferably a non-reactive or protected reactive organic group, which has preferably 5 or more C-atoms.

Especially preferably R¹ is straight chain, branched or cyclic alkyl with 1 or more, preferably 5 or more, very preferably 1 to 20 C-atoms, which may be unsubstituted, mono- or poly-substituted by F, Cl, Br, I or CN, it being also possible for one or more non-adjacent CH₂ groups to be replaced, in each case independently from one another, by -0-, -S-, -NH-, -NR⁰-, -SiR⁰R⁰⁰-, -CO-, -COO-, -OCO-, - OCO-O-, -SO₂-, -S-CO-, -CO-S-, -CY¹=CY²- or -C≡C- in such a manner that O and/or S atoms are not linked directly to one another, optionally substituted aryl or heteroaryl preferably having 1 to 30 C-atoms, or P-Sp, with
- R⁰ and R⁰⁰: being independently of each other H or alkyl with 1 to 12 C-atoms,
- Y¹ and Y²: being independently of each other H, F, Cl or CN,
- P: being a polymerisable or reactive group which is optionally protected, and
- Sp: being a spacer group or a single bond.

X¹ and X² in formula 11 and II are preferably independently of each other selected from Cl or Br, most preferably Br.

X¹¹ and X²² in formula I2 are preferably independently of each other selected from H, halogen, B(OR')(OR") or SnR⁰R⁰⁰R⁰⁰⁰ or straight chain, branched or cyclic alkyl with 1 to 20 C-atoms, which may be unsubstituted, mono- or poly-substituted by F, Cl, Br, I, -CN and/ or - OH, it being also possible for one or more non-adjacent CH₂ groups to be replaced, in each case independently from one another, by -O-, -S-, -NH-, -NR⁰-, -SiR⁰R⁰⁰-, -CO-, -COO-, -OCO-, -OCO-O-, -S-CO-, - CO-S-, -CY¹=CY²- or -C≡C- in such a manner that O and/or S atoms are not linked directly to one another, optionally substituted aryl or heteroaryl, or P-Sp, with R⁰, R⁰⁰, Y¹, Y², P and Sp having the meanings given above,
- R⁰⁰⁰: being H or alkyl with 1 to 12 C-atoms, and
- R' and R": being independently of each other H or alkyl with 1 to 12 C-atoms, or OR' and OR" together with the boron atom may also form a cyclic group having 2 to 10 C atoms.

Especially preferred are polymers and compounds of formula I, II, I1 and I2 wherein
- R¹ is an organic group, preferably an alkyl group with 5 or more C-atoms,
- R¹ is a straight-chain alkyl group with 1 to 12, preferably 5 to 12 C-atoms,
- R¹ is n-hexyl,
- R¹ is selected from C₁-C₂₀-alkyl that is optionally substituted with one or more fluorine atoms, C₁-C₂₀-alkenyl, C₁-C₂₀-alkynyl, C₁-C₂₀-alkoxy, C₁-C₂₀-thioalkyl, C₁-C₂₆-silyl, C₁-C₂₀-ester, C₁-C₂₀-amino, C₁-C₂₀-fluoroalkyl, optionally substituted aryl or heteroaryl, or P-Sp-, in particular C₁-C₂₀-alkyl or C₁-C₂₀-fluoroalkyl, preferably straight-chain groups,
- R¹ is selected from alkyl that is optionally substituted with one or more fluorine atoms, alkenyl, alkynyl, alkoxy, thioalkyl or fluoroalkyl, all of which are straight-chain and have 1 to 12, preferably 5 to 12 C-atoms,
- R¹ is selected from pentyl, hexyl, heptyl, octyl, nonyl, decyl, undecyl or dodecyl,
- X¹ and X² have the same meaning,
- X¹ and X² denote Br,
- X¹¹ and X²² have the same meaning,
- X¹¹ and X²² denote H,
- X¹¹ and X²² are selected from alkyl that is optionally substituted with one or more fluorine atoms, alkenyl, alkynyl, alkoxy, thioalkyl, silyl, ester, amino or fluoroalkyl, all of these groups being straight-chain or branched and having 1 to 20, preferably 1 to 12, most preferably 1 to 6 C atoms, or optionally substituted aryl or heteroaryl, or P-Sp as defined above, in particular straight-chain or branched C₁-C₆-alkyl, most preferably isopropyl, tert. butyl, or 2-methylbutyl,
- n is an integer from 2 to 5000, in particular 50 to 1000.

If in formula I, I1, I1 and I2 R¹ is an alkyl or alkoxy radical, i.e. where the terminal CH₂ group is replaced by -O-, this may be straight-chain or branched. It is preferably straight-chain, has 2 to 8 carbon atoms and accordingly is preferably ethyl, propyl, butyl, pentyl, hexyl, heptyl, octyl, ethoxy, propoxy, butoxy, pentoxy, hexyloxy, heptoxy, or octoxy, furthermore methyl, nonyl, decyl, undecyl, dodecyl, tridecyl, tetradecyl, pentadecyl, nonoxy, decoxy, undecoxy, dodecoxy, tridecoxy or tetradecoxy, for example. Especially preferred are n-hexyl and n-dodecyl.

If in formula I, II, 11 and 12 R¹ is oxaalkyl, i.e. where one CH₂ group is replaced by -0-, is preferably straight-chain 2-oxapropyl (=methoxymethyl), 2- (=ethoxymethyl) or 3-oxabutyl (=2-methoxyethyl), 2-, 3-, or 4-oxapentyl, 2-, 3-, 4-, or 5-oxahexyl, 2-, 3-, 4-, 5-, or 6-oxaheptyl, 2-, 3-, 4-, 5-, 6- or 7-oxaoctyl, 2-, 3-, 4-, 5-, 6-, 7- or 8-oxanonyl or 2-, 3-, 4-, 5-, 6-,7-, 8- or 9-oxadecyl, for example.

If in formula I, II and 11 R¹ is thioalkyl, i.e where one CH₂ group is replaced by -S-, is preferably straight-chain thiomethyl (-SCH₃), 1-thioethyl (-SCH₂CH₃), 1-thiopropyl (= -SCH₂CH₂CH₃), 1- (thiobutyl), 1-(thiopentyl), 1-(thiohexyl), 1-(thioheptyl), 1-(thiooctyl), 1-(thiononyl), 1-(thiodecyl), 1-(thioundecyl) or 1-(thiododecyl), wherein preferably the CH₂ group adjacent to the sp² hybridised vinyl carbon atom is replaced.

If in formula I, II, I1 and I2 R¹ is fluoroalkyl, it is preferably straight-chain perfluoroalkyl CᵢF₂ᵢ₊₁, wherein i is an integer from 1 to 15, in particular CF₃, C₂F₅, C₃F₇, C₄F₉, C₅F₁₁, C₆F_{13,} C₇F₁₅ or C₈F₁₇, very preferably C₆F_{13.}

Halogen is preferably F, Br or Cl.
-CY¹=CY²- is preferably -CH=CH-, -CF=CF- or -CH=C(CN)-.

Aryl and heteroaryl preferably denote a mono-, bi- or tricyclic aromatic or heteroaromatic group with up to 25 C atoms that may also comprise condensed rings and is optionally substituted with one or more groups L, wherein L is halogen or an alkyl, alkoxy, alkylcarbonyl or alkoxycarbonyl group with 1 to 12 C atoms, wherein one or more H atoms may be replaced by F or Cl.

Especially preferred aryl and heteroaryl groups are phenyl in which, in addition, one or more CH groups may be replaced by N, naphthalene, thiophene, thienothiophene, dithienothiophene, alkyl fluorene and oxazole, all of which can be unsubstituted, mono- or polysubstituted with L as defined above.

Another preferred embodiment of the present invention relates to polythiophenes that are substituted in 3-position with a polymerisable or reactive group, which is optionally protected during the process of forming the polythiophene. Particular preferred polymers of this type are those of formula I, I1 or I2 wherein R¹ denotes P-Sp. These polymers are particularly useful as semiconductors or charge transport materials, as they can be crosslinked via the groups P, for example by polymerisation in situ, during or after processing the polymer into a thin film for a semiconductor component, to yield crosslinked polymer films with high charge carrier mobility and high thermal, mechanical and chemical stability.

The polymerisable or reactive group P is preferably selected from 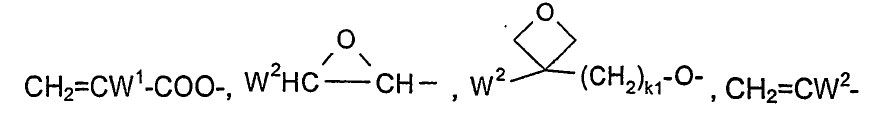 (0)ₖ₁-, CH₃-CH=CH-O-, (CH₂=CH)₂CH-OCO-, (CH₂=CH)₂CH-O-, (CH₂=CH-CH₂)₂CH-OCO-, (CH₂=CH-CH₂)₂N-, HO-CW²W³-, HS-CW²W³-, HW²N-, HO-CW²W³-NH-, CH₂=CW¹-CO-NH-, CH₂=CH-(COO)ₖ₁-Phe-(O)ₖ₂-, Phe-CH=CH-, HOOC-, OCN-, and W⁴W⁵W⁶Si-, with W¹ being H, Cl, CN, phenyl or alkyl with 1 to 5 C-atoms, in particular H, Cl or CH₃, W² and W³ being independently of each other H or alkyl with 1 to 5 C-atoms, in particular methyl, ethyl or n-propyl, W⁴, W⁵ and W⁶ being independently of each other Cl, oxaalkyl or oxacarbonylalkyl with 1 to 5 C-atoms, Phe being 1,4-phenylene and k₁ and k₂ being independently of each other 0 or 1, or a protected derivative of these groups which is non-reactive with magnesium under the conditions described for the process according to the present invention. Suitable protective groups are known to the expert and described in the literature, for example in Greene and Greene, "Protective Groups in Organic Synthesis", John Wiley and Sons, New York (1981), like for example acetals or ketals.

Preferably, however, the polymerisable group is added to the inventive polymers as the last step, after polymerisation.

Especially preferred groups P are CH₂=CH-COO-, CH₂=C(CH₃)-COO-, CH₂=CH-, CH₂=CH-O-, (CH₂=CH)₂CH-OCO-, (CH₂=CH)₂CH- 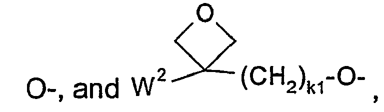 or protected derivatives thereof.

Polymerisation of group P can be carried out according to methods that are known the expert and described in the literature, for example in D. J. Broer; G. Challa; G. N. Mol, *Macromol. Chem,* 1991,**192**,59.

As spacer group Sp all groups can be used that are known for this purpose to the skilled in the art. The spacer group Sp is preferably of formula Sp'-X', such that P-Sp- is P-Sp'-X'-, wherein
- Sp': is alkylene with up to 30 C atoms which is unsubstituted or mono- or polysubstituted by F, Cl, Br, I or CN, it being also possible for one or more non-adjacent CH₂ groups to be replaced, in each case independently from one another, by -O-, -S-, -NH-, -NR⁰-, -SiR⁰R⁰⁰- -CO-, -COO-, -OCO-, -OCO-O-, -S-CO-, -CO-S-, -CH=CH- or -C≡C-in such a manner that O and/or S atoms are not linked directly to one another,
- X': is -O-, -S-, -CO-, -COO-, -OCO-, -O-COO-, -CO-NR⁰-, -NR⁰-CO-, -OCH₂-, -CH₂O-, -SCH₂-, -CH₂S-, -CF₂O-, -OCF₂-, -CF₂S-, -SCF₂-, -CF₂CH₂-, -CH₂CF₂-, -CF₂CF₂-, -CH=N-, -N=CH-, -N=N-, -CH=CR⁰-, -CY¹=CY²-, -C≡C-, -CH=CH-COO-, -OCO-CH=CH- or a single bond,
- R⁰ and R⁰⁰: are independently of each other H or alkyl with 1 to 12 C-atoms, and
- Y¹ and Y²: are independently of each other H, F, Cl or CN.

X' is preferably -O-, -S-, -OCH₂-, -CH₂O-, -SCH₂-, -CH₂S-, -CF₂O-, -OCF₂-, -CF₂S-, -SCF₂-, -CH₂CH₂-, -CF₂CH₂-, -CH₂CF₂-, -CF₂CF₂-, -CH=N-, -N=CH-, -N=N-, -CH=CR⁰-, -CY¹=CY²-, -C≡C- or a single bond, in particular -O-, -S-, -C≡C-, -CY¹=CY²- or a single bond. In another preferred embodiment X' is a group that is able to form a conjugated system, such as -C≡C- or -CY¹=CY²-, or a single bond.

Typical groups Sp' are, for example, -(CH₂)ₚ-, -(CH₂CH₂O)_{q} -CH₂CH₂-, -CH₂CH₂-S-CH₂CH₂- or -CH₂CH₂-NH-CH₂CH₂- or -(SiR⁰R⁰⁰-O)ₚ-, with p being an integer from 2 to 12, q being an integer from 1 to 3 and R⁰ and R⁰⁰ having the meanings given above.

Preferred groups Sp' are ethylene, propylene, butylene, pentylene; hexylene, heptylene, octylene, nonylene, decylene, undecylene, dodecylene, octadecylene, ethyleneoxyethylene, methyleneoxybutylene, ethylene-thioethylene, ethylene-N-methyliminoethylene, 1-methylalkylene, ethenylene, propenylene and butenylene for example.

The polymers of the present invention are useful as optical, electronic and semiconductor materials, in particular as charge transport materials in field effect transistors (FETs), e.g., as components of integrated circuitry, ID tags or TFT applications. Alternatively, they may be used in organic light emitting diodes (OLEDs) in electroluminescent display applications or as backlight of, e.g., liquid crystal displays, as photovoltaics or sensor materials, for electrophotographic recording, and for other semiconductor applications.

The polymers according to the present invention show especially advantageous solubility properties which allow production processes using solutions of these compounds. Thus films, including layers and coatings, may be generated by low cost production techniques, e.g., spin coating. Suitable solvents or solvent mixtures comprise alkanes and/ or aromatics, especially their fluorinated or chlorinated derivatives.

The polymers of the present invention are especially useful as charge transport materials in FETs. Such FETs, where an organic semiconductive material is arranged as a film between a gate-dielectric and a drain and a source electrode, are generally known, e.g., from US 5,892,244, WO 00/79617, US 5,998,804, and from the references cited in the background and prior art chapter and listed below. Due to the advantages, like low cost production using the solubility properties of the compounds according to the invention and thus the processibility of large surfaces, preferred applications of these FETs are such as integrated circuitry, TFT-displays and security applications.

In security applications, field effect transistors and other devices with semiconductive materials, like transistors or diodes, may be used for ID tags or security markings to authenticate and prevent counterfeiting of documents of value like banknotes, credit cards or ID cards, national ID documents, licenses or any product with money value, like stamps, tickets, shares, cheques etc..

Alternatively, the polymers according to the invention may be used in organic light emitting devices or diodes (OLEDs), e.g., in display applications or as backlight of e.g. liquid crystal displays. Common OLEDs are realized using multilayer structures. An emission layer is generally sandwiched between one or more electron-transport and/or hole-transport layers. By applying an electric voltage electrons and holes as charge carriers move towards the emission layer where their recombination leads to the excitation and hence luminescence of the lumophor units contained in the emission layer. The inventive compounds, materials and films may be employed in one or more of the charge transport layers and/ or in the emission layer, corresponding to their electrical and/ or optical properties. Furthermore their use within the emission layer is especially advantageous, if the polymers according to the invention show electroluminescent properties themselves or comprise electroluminescent groups or compounds. The selection, characterization as well as the processing of suitable monomeric, oligomeric and polymeric compounds or materials for the use in OLEDs is generally known by a person skilled in the art, see, e.g., Meerholz, Synthetic Materials, 111-112, 2000, 31-34, Alcala, J. Appl. Phys., 88, 2000, 7124-7128 and the literature cited therein.

According to another use, the polymers according to the present invention, especially those which show photoluminescent properties, may be employed as materials of light sources, e.g., of display devices such as described in EP 0 889 350 A1 or by C. Weder et al., Science, 279, 1998, 835-837.

A further aspect of the invention relates to both the oxidised and reduced form of the polymers according to this invention. Either loss or gain of electrons results in formation of a highly delocalised ionic form, which is of high conductivity. This can occur on exposure to common dopants. Suitable dopants and methods of doping are known to those skilled in the art, e.g., from EP 0 528 662, US 5,198,153 or WO 96/21659.

The doping process typically implies treatment of the semiconductor material with an oxidating or reducing agent in a redox reaction to form delocalised ionic centres in the material, with the corresponding counterions derived from the applied dopants. Suitable doping methods comprise for example exposure to a doping vapor in the atmospheric pressure or at a reduced pressure, electrochemical doping in a solution containing a dopant, bringing a dopant into contact with the semiconductor material to be thermally diffused, and ion-implantantion of the dopant into the semiconductor material.

When electrons are used as carriers, suitable dopants are for example halogens (e.g., I₂, Cl₂, Br₂, ICI, ICI₃, IBr and IF), Lewis acids (e.g., PF₅, AsF₅, SbF₅, BF₃, BCl₃, SbCl₅, BBr₃ and SO₃), protonic acids, organic acids, or amino acids (e.g., HF, HCl, HNO₃, H₂SO₄, HClO₄, FSO₃H and ClSO₃H), transition metal compounds (e.g., FeCl₃, FeOCl, Fe(ClO₄)₃, Fe(4-CH₃C₆H₄SO₃)₃, TiCl₄, ZrCl₄, HfCl₄, NbF₅, NbCl₅, TaCl₅, MoF₅, MoCl₅, WF₅, WCl₆, UF₆ and LnCl₃ (wherein Ln is a lanthanoid), anions (e.g., Cl⁻, Br⁻, I⁻, I₃⁻, HSO₄⁻, SO₄²⁻, NO₃⁻, ClO₄⁻, BF₄⁻, PF₆⁻, AsF₆⁻, SbF₆⁻, FeCl₄⁻, Fe(CN)₆³⁻, and anions of various sulfonic acids, such as aryl-SO₃⁻). When holes are used as carriers, examples of dopants are cations (e.g., H⁺, Li⁺, Na⁺, K⁺, Rb⁺ and Cs⁺), alkali metals (e.g., Li, Na, K, Rb, and Cs), alkaline-earth metals (e.g., Ca, Sr, and Ba), O₂, XeOF₄, (NO₂⁺) (SbF₆⁻), (NO₂⁺) (SbCl₆⁻), (NO₂⁺) (BF₄⁻), AgClO₄, H₂IrCl₆, La(NO₃)₃ 6H₂O, FSO₂OOSO₂F, Eu, acetylcholine, R₄N⁺; (R is an alkyl group), R₄P⁺ (R is an alkyl group), R₆As⁺ (R is an alkyl group), and R₃S⁺ (R is an alkyl group).

The conducting form of the polymers of the present invention can be used as an organic "metal" in applications, for example, but not limited to, charge injection layers and ITO planarising layers in organic light emitting diode applications, films for flat panel displays and touch screens, antistatic films, printed conductive substrates, patterns or tracts in electronic applications such as printed circuit boards and condensers.

According to another use the polymers according to the present invention, especially their water-soluble derivatives (for example with polar or ionic side groups) or ionically doped forms, can be employed as chemical sensors or materials for detecting and discriminating DNA sequences. Such uses are described for example in L. Chen, D. W. McBranch, H. Wang, R. Helgeson, F. Wudl and D. G. Whitten, Proc. Natl. Acad. Sci. U.S.A. 1999, 96, 12287; D. Wang, X. Gong, P. S. Heeger, F. Rininsland, G. C. Bazan and A. J. Heeger, Proc. Natl. Acad. Sci. U.S.A. 2002, 99, 49; N. DiCesare, M. R. Pinot, K. S. Schanze and J. R. Lakowicz, Langmuir 2002, 18, 7785; D. T. McQuade, A. E. Pullen, T. M. Swager, Chem. Rev. 2000, 100, 2537.

The examples below serve to illustrate the invention without limiting it. In the foregoing and the following, all temperatures are given in degrees Celsius, and all percentages are by weight, unless stated otherwise.

### Example 1

### a) Polymerisation:

9,7g of 2,5-dibromo-3-hexylthiophene are dissolved in 100 ml diethylether. To 10 % of this prepared solution 0,8 g magnesium are added and heated to reflux. The Grignard reaction is started by adding one drop of bromine. The rest (90%) of the prepared solution is added to the reaction mixture during 30 minutes and refluxed for further 2 hours. Then the excess magnesium is filtered off, the reaction cooled down to 0 °C and 0,2 g of Ni(dppp)Cl₂ are added to start the polymerisation, and the reaction heated to reflux.

### b) Work-up and Purification:

After 2 more hours of refluxing, 4 ml of isopropylmagnesium chloride (2 mol/l in diethyl ether) is added for H-endcapping.

After a reaction time of 2 hours the endcapping is finished and the reaction mixture is quenched with aqueous methanol. Extracting the product from the aqueous phase with chloroform and precipitating it into methanol gives the crude polymer which is further purified by Soxhlet extractions with methanol and heptane. Thus, 2.5g (50%) of pure poly-3-hexylthiophene (¹H-NMR regioregularity > 95 %) are obtained. The molecular weight determined by GPC is Mₙ = 12,600, M_{w} = 21,700, the polydispersity is 1,7.

### Comparison Example 1 (diiodo instead of dibromo monomer)

Example 1 is repeated but with using 2,5-diiodo-3-hexylthiophene instead of 2,5-dibromo-3-hexylthiophene in the same molar amounts. However the mixture of Grignard intermediates precipitates and cannot be polymerised. Changing the concentration keeps the intermediate products in solution but after polymerisation an oily product is obtained which cannot be precipitated from methanol and is soluble in hot heptane, indicating a low molecular weight. Regioregularity is only around 70%.

### Comparison Example 2 (THF instead of linear ether as solvent)

Example 1 is repeated but with using THF instead of diethyl ether as solvent. As a result a low molecular weight product is obtained that is soluble in hot heptane and has a regioregularity only around 90%.

### Example 2 - Endcapping (replacing Br by H)

Poly-3-hexylthiophene is prepared as described in example 1a). At the end of the polymerisation reaction a portion of the reaction mixture is end capped with H as described in example 1b) and a portion is worked up without endcapping by immediate precipitation prior to the addition of the Grignard reagent. Analysis by MALDI-TOF mass spectroscopy (Matrix-Assisted Laser-Desorption/Ionization Time-Of-Flight, see M. Karas and F. Hillenkamp, Anal. Chem. 1988, 60, 2299 and J. Liu., R. S. Loewe and R. D. McCullough, Macromolecules, 1999, 32, 5777) indicate that the endcapped sample has predominantly H end groups, whereas the non-endcapped sample has a much higher amount of bromine end groups.

### Example 3 - Endcapping (replacing Br by Propyl)

Poly-3-hexylthiophene is prepared as described in example 1a). At the end of the polymerisation reaction a portion of the reaction mixture is end capped with an alkyl group by first adding isopropylmagnesium chloride (2 mol/L in diethylether) and after two hours adding 1-Bromopropane. The other portion is worked up with out endcapping. MALDI-TOF MS analysis indicates that the endcapped sample has predominantly propyl end groups where as the non-endcapped sample has a much higher amount of bromine end groups.

### Example 4 - Use of endcapped polymer in a transistor

Measurements of the maximum current versus voltage are carried out for Br-terminated and H-endcapped polymers of examples 1 and 2 using substrates and processing conditions as follows.

Thin-film organic field-effect transistors (OFETs) are fabricated on highly doped silicon substrates with a thermally grown silicon oxide (SiO₂) insulating layer, where the substrate served as a common gate electrode. Transistor source-drain gold electrodes are photolithographically defined on the SiO₂ layer. Prior to organic semiconductor deposition, FET substrates are treated with a silylating agent hexamethyldisilazane (HMDS). Thin semiconductor films are then deposited by spin-coating polymer solutions in chloroform on to the FET substrates. The electrical characterization of the transistor devices, is carried out in a dry nitrogen atmosphere using computer controlled Agilent 4155C Semiconductor Parameter Analyser.

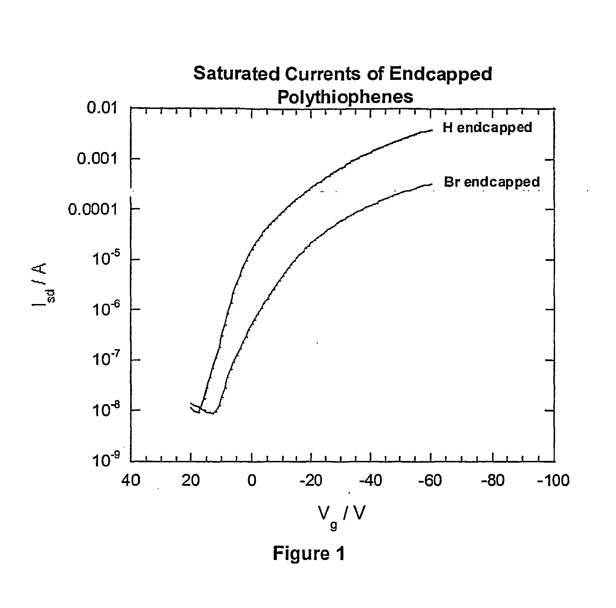

The results are shown in **Figures 1-3****.** The effect of the end groups can be seen in the following ways:

As can be seen in **Figure 1****,** maximum current (and hence mobility) is higher for samples with H end capping with respect to Br end capping. Samples with H have a higher sub threshold slope.

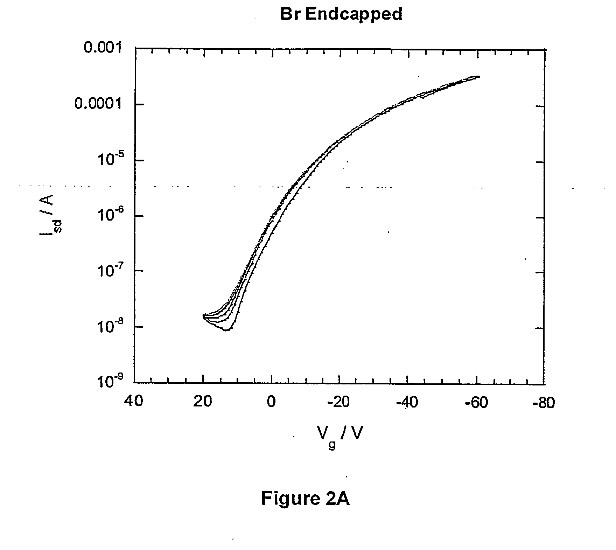

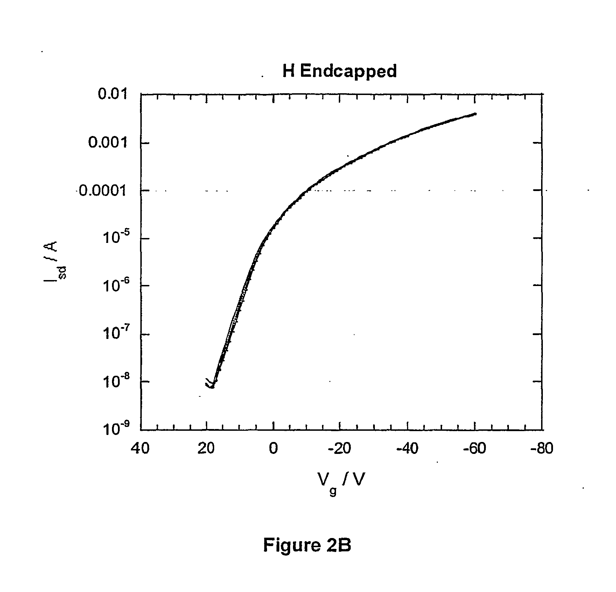

As can be seen in **Figure 2A** and **2B****,** stability of the samples to repeated scanning is superior for samples with H end caps (2B) than for those with bromine end caps (2A).

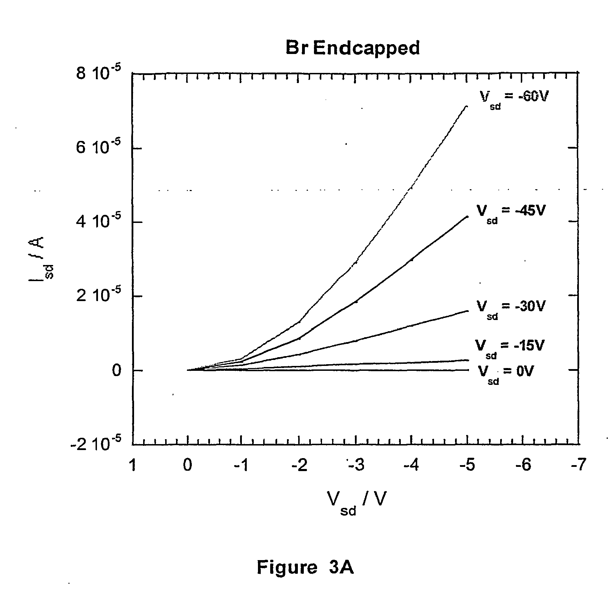

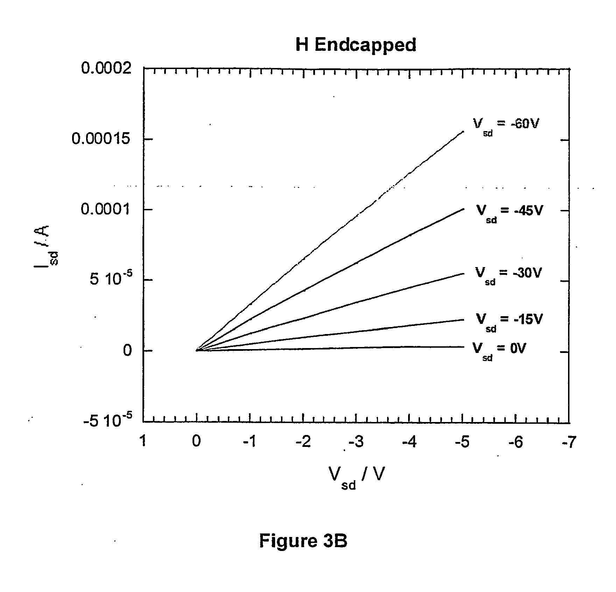

Finally, as can be seen in the transitor output scans **Figure 3A** and **3B****,** at low source-drain voltage H-capped samples (3B) show good ohmic contact behaviour. The sample with H capping shows perfect linear behaviour. The Br capped sample (3A) however displays significant contact resistance as can be seen by the non-linear behaviour of the current-voltage plot around 0V.

## Claims

1. Process of preparing a regioregular poly (3-substituted thiophene) by providing a 3-substituted thiophene having chloro and/or bromo groups in 2- and 5-position, reacting said thiophene with magnesium in a solvent selected from the group consisting of linear ethers, mixtures thereof, and mixtures of toluene with one or more linear ethers, and polymerising the formed regiochemical Grignard intermediate or mixture of regiochemical Grignard intermediates by adding a suitable catalyst.

2. Process according to claim 1, by
a) dissolving the 3-substituted thiophene in a solvent or a mixture of solvents selected from the group consisting of linear ethers, mixtures thereof, and mixtures of toluene with one or more linear ethers,
b) adding magnesium in an at least molar amount of the thiophene to the solution, or adding the solution to said magnesium, wherein said magnesium reacts with said thiophene to form a regiochemical Grignard intermediate or a mixture of regiochemical Grignard intermediates,
c) optionally removing the unreacted magnesium from the reaction mixture,
d) adding a catalyst to the reaction mixture, or adding the reaction mixture to a catalyst, and optionally agitating the mixture, to form a polymer, and
e) recovering the polymer from the mixture.

3. Process according to claim 1 or 2, **characterized in that** the substituent in 3-position of the thiophene is an organic group which when it is unsubstituted and unmodified straight chained or branched alkyl has 5 or more C-atoms.

4. Process according to at least one of claims 1 to 3, **characterized in that** the 3-substituted thiophene is a 3-substituted 2,5-dibromo-thiophene.

5. Process according to at least one of claims 1 to 4, **characterized in that** the poly (3-substituted thiophene) has a regioregularity of ≥ 95 % HT couplings.

6. Process according to at least one of claims 1 to 5, **characterized in that** the solvent is selected from diethyl ether, di-n-butyl ether, di-n-propyl ether, di-isopropyl ether, ethers with two different alkyl groups, 1,2-dimethyoxyethane or t-butylmethyl ether, or mixtures thereof, or mixtures of toluene with one or more of the above ethers.

7. Process according to claim 6, **characterized in that** the solvent is diethyl ether.

8. Process according to at least one of claims 2 to 7, **characterized in that** the concentration of the thiophene in the solution in step
a) is from 40 to 200 grams per litre.

9. Process according to at least one of claims 1 to 8, **characterized in that** the amount of the magnesium is from > 1 to 3 times the molar amount of the thiophene educt.

10. Process according to claim 9, **characterized in that** the amount of the magnesium is from 1.02 to 1.20 times the molar amount of the thiophene educt.

11. Process according to at least one of claims 1 to 10, **characterized in that** the unreacted magnesium is removed from the reaction mixture before adding the catalyst.

12. Process according to at least one of claims 1 to 11, **characterized in that** the catalyst is a Ni(II) catalyst.

13. Process according to claim 12, **characterized in that** the catalyst is selected from Ni(dppp)Cl₂ (1,3-diphenylphosphinopropane nickel(II) chloride) or Ni(dppe)Cl₂ (1,2bis(diphenylphosphino)ethane nickel(II) chloride).

14. Process according to at least one of claims 1 to 13, **characterized in that** the formation of the regiochemical Grignard intermediate and the polymerisation (steps a) and d)) are carried out at a temperature from room temperature to reflux temperature.

15. Process according to claim 14, **characterized in that** the formation of the regiochemical Grignard intermediate and the polymerisation (steps a) and d)) are carried out at reflux temperature.

16. Process according to at least one of claims 1 to 15, **characterized in that** the polymer is purified after being recovered from the reaction mixture.

17. Process according to at least one of claims 1 to 16, **characterized in that** the polymer is selected of formula I 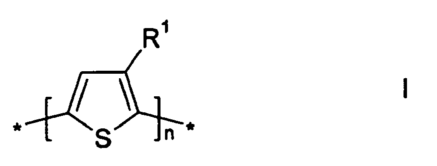 wherein n is from 10 to 5,000 and R¹ is a group that does not react with magnesium under the conditions of the process according to any of the preceding or following claims.

18. Process according to at least one of claims 1 to 17, **characterized in that** the 3-substituted thiophene is selected of formula II 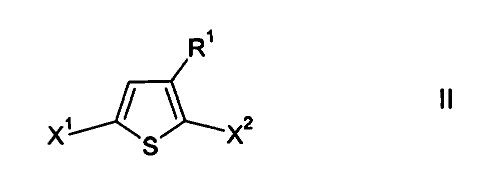 wherein R¹ has the meaning of claim 17, and X¹ and X² are independently of each other Br or Cl.

19. Process according to claim 17 or 18, **characterized in that** R¹ is straight chain, branched or cyclic alkyl with 1 or more C-atoms, which may be unsubstituted, mono- or poly-substituted by F, Cl, Br, I or CN, it being also possible for one or more non-adjacent CH₂ groups to be replaced, in each case independently from one another, by -O-, -S-, -NH-, -NR⁰-, -SiR⁰R⁰⁰-, -CO-, -COO-, - OCO-, -OCO-O-, -SO₂-, -S-CO-, -CO-S-, -CY¹=CY²- or -C=C- in such a manner that O and/or S atoms are not linked directly to one another, optionally substituted aryl or heteroaryl, or P-Sp-, with
R⁰ and R⁰⁰ being independently of each other H or alkyl with 1 to 12 C-atoms,
Y¹ and Y² being independently of each other H, F, Cl or CN,
P being a polymerisable or reactive group which is optionally protected, and
Sp being a spacer group or a single bond.

20. Process according to claim 19, **characterized in that** R¹ is selected from C₁-C₂₀-alkyl that is optionally substituted with one or more fluorine atoms, C₁-C₂₀-alkenyl, C₁-C₂₀-alkynyl, C₁-C₂₀-alkoxy, C₁-C₂₀-thioalkyl, C₁-C₂₀-Silyl, C₁-C₂₀-ester, C₁-C₂₀-amino, C₁-C₂₀-fluoroalkyl.

21. Process according to claim 20, **characterized in that** R¹ is selected from straight-chain or branched pentyl, hexyl, heptyl, octyl, nonyl, decyl, undecyl or dodecyl.

22. Process according to claim 21, **characterized in that** R¹ is n-hexyl.

23. Process according to at least one of claims 17 to 22, **characterized in that** X¹ and X² are Br.

24. Process according to at least one of claims 17 to 23, **characterized in that** n is an integer from 50 to 1,000.

25. Process according to at least one of claims 1 to 24, **characterized in that** the polymer is selected of formula 11 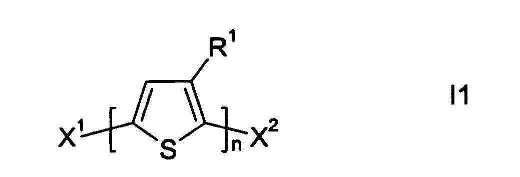 wherein n, R¹, X¹ and X² have the meanings of claims 17 to 24.

26. Process according to at least one of claims 1 to 25, **characterized in that** one or more of the terminal groups of the polymer are chemically modified ('endcapped').

27. Process according to claim 26, **characterized in that** the polymer after endcapping is of formula 12 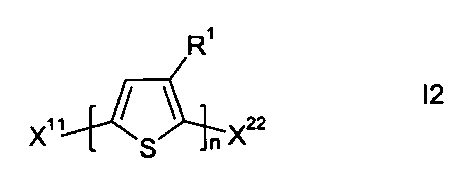 wherein n and R¹ have the meanings of claims 17 to 24,
X¹¹ and X²² are independently of each other H, halogen, Sn(R⁰)₃ or straight chain, branched or cyclic alkyl with 1 to 20 C-atoms, which may be unsubstituted, mono- or poly-substituted by F, Cl, Br, I, -CN and/or -OH, it being also possible for one or more non-adjacent CH₂ groups to be replaced, in each case independently from one another, by -O- -S-, -NH-, -NR⁰-, -SiR⁰R⁰⁰-, -CO-, -COO-, -OCO-, -OCO-O-, -S-CO-, -CO-S-, -CY¹=CY²- or -C≡C- in such a manner that O and/or S atoms are not linked directly to one another, optionally substituted aryl or heteroaryl, P-Sp- as defined in claim 19, or a reactive or protected reactive group,
R⁰ and R⁰⁰ are independently of each other H or alkyl with 1 to 12 C-atoms, and
Y¹ and Y² are independently of each other H, F, Cl or CN.

28. Process according to claim 27, **characterized in that** X¹¹ and X²² are independently of each other alkyl that is optionally substituted with one or more fluorine atoms, alkenyl, alkynyl, alkoxy, thioalkyl, silyl, ester, amino or fluoroalkyl, all of these groups being straight-chain or branched and having 1 to 20 C atoms, or optionally substituted aryl or heteroaryl, or P-Sp- as defined in claim 19.

29. Process according to claim 28, **characterized in that** X¹¹ and X²² denote straight-chain or branched alkyl with 1 to 6 C atoms.

30. Process according to claim 27, **characterized in that** X¹¹ and X²² are selected from hydroxy, amine, aldehyde, stannate or boronate groups.

31. Process according to claim 27 or 30, **characterized in that** the polymer of formula 12 is further reacted via end group X¹¹ and/or X²² with the same or a different polymer of formula 12, or with another polymer, to form a block copolymer.

32. Polymer obtainable by a process according to claim 27, **characterized in that** it is of formula I2 wherein
R¹ is straight-chain, branched or cyclic alkyl with 1 to 20 C-atoms, n is from 10 to 5,000,
X¹¹ and X²² are selected from alkyl that is optionally substituted with one or more fluorine atoms, alkenyl, alkynyl, alkoxy, thioalkyl, silyl, or fluoroalkyl, all of these groups being straight-chain or branched and having 1 to 20 C atoms, optionally substituted aryl or heteroaryl, or P-Sp,
P is selected from CH₂=CH-COO-, CH₂=C(CH₃)-COO-,
CH₂=CH-, CH₂=CH-O-, (CH₂=CH)₂CH-OCO-, (CH₂=CH)₂CH-O-, 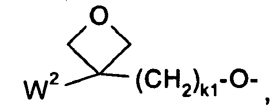 or protected derivatives thereof,
W² is H or alkyl with 1 to 5 C-atoms, in particular methyl, ethyl or n-propyl, k₁ is 0 or 1 and Sp is a spacer group or a single bond.

33. Polymer according to claim 32, **characterized in that** X¹¹ and X²² are selected from straight-chain or branched alkyl with 1 to 12 C atoms.

34. Polymer according to claim 32 or 33, **characterized in that** R¹ is selected from straight-chain or branched pentyl, hexyl, heptyl, octyl, nonyl, decyl, undecyl or dodecyl.

35. Use of a polymer according to at least one of claims 32 to 34 as semiconductor or charge transport material, in particular in optical, electrooptical or electronic devices, like for example in field effect transistors (FET) as components of integrated circuitry, as thin film transistors in flat panel display applications or for Radio Frequency Identification (RFID) tags, or in semiconducting components for organic light emitting diode (OLED) applications such as electroluminescent displays or backlights of e.g. liquid crystal displays (LCD), for photovoltaic or sensor devices, as electrode materials in batteries, as photoconductors, for electrophotographic applications like electrophotographic recording or for detecting and discriminating DNA sequences.

36. Use of a polymer according to at least one of claims 32 to 34 as electroluminescent material, in photovoltaic or sensor devices, as electrode materials in batteries, as photoconductors, for electrophotographic applications or electrophotographic recording.

37. Semiconductor or charge transport material, component or device comprising one or more polymers according to at least one of claims 32 to 34.

38. Optical, electrooptical or electronic device, FET, integrated circuit (IC), TFT or OLED comprising a semiconducting or charge transport material, component or device according to claim 37.

39. TFT or TFT array for flat panel displays, radio frequency identification (RFID) tag, electroluminescent display or backlight comprising a semiconducting or charge transport material, component or device or a FET, IC, TFT or OLED according to claim 37 or 38.

40. Security marking or device comprising a FET or an RFID tag according to claim 39.

41. Polymer according to at least one of claims 32 to 34 which is oxidatively or reductively doped to form conducting ionic species.

42. Charge injection layer, planarising layer, antistatic film or conducting substrate or pattern for electronic applications or flat panel displays, comprising a polymer according to claim 41.

## Patentansprüche

1. Verfahren zur Herstellung eines regioregulären Poly(3-substituierten Thiophens) durch Bereitstellen eines 3-substituierten Thiophens mit Chlor- und/oder Bromgruppen in 2- und 5-Position, Umsetzen des Thiophens mit Magnesium in einem Lösungsmittel ausgewählt aus der Gruppe bestehend aus linearen Ethern, deren Mischungen und Mischungen aus Toluol und einem oder mehreren linearen Ethern und Polymerisieren des gebildeten regiochemischen Grignard-Zwischenproduktes oder der Mischung aus regiochemischen Grignard-Zwischenprodukten durch Zugabe eines geeigneten Katalysators.

2. Verfahren nach Anspruch 1, durch
a) Lösen des 3-substituierten Thiophens in einem Lösungsmittel oder einer Lösungsmittelmischung ausgewählt aus der Gruppe bestehend aus linearen Ethern, deren Mischungen und Mischungen aus Toluol und einem oder mehreren linearen Ethern,
b) Zugabe von Magnesium in einer mindestens molaren Menge des Thiophens zu der Lösung oder Zugeben der Lösung zum Magnesium, wobei das Magnesium mit dem Thiophen unter Bildung eines regiochemischen Grignard-Zwischenproduktes oder einer Mischung aus regiochemischen Grignard-Zwischenprodukten reagiert,
c) gegebenenfalls Entfernen des nicht umgesetzten Magnesiums aus der Reaktionsmischung,
d) Zugabe eines Katalysators zur Reaktionsmischung oder Zugeben der Reaktionsmischung zu einem Katalysator, und gegebenenfalls Bewegen der Mischung zur Bildung eines Polymers und
e) Wiedergewinnen des Polymers aus der Mischung.

3. Verfahren nach Anspruch 1 oder 2, **dadurch gekennzeichnet, dass** der Substituent in 3-Position des Thiophens eine organische Gruppe ist, welche, wenn sie unsubstituiertes und unmodifiziertes geradkettiges oder verzweigtes Alkyl bedeutet, 5 oder mehr C-Atome aufweist.

4. Verfahren nach mindestens einem der Ansprüche 1 bis 3, **dadurch gekennzeichnet, dass** es sich bei dem 3-substituierten Thiophen um ein 3-substituiertes 2,5-Dibrom-thiophen handelt.

5. Verfahren nach mindestens einem der Ansprüche 1 bis 4, **dadurch gekennzeichnet, dass** das Poly(3-substituierte Thiophen) eine Regioregularität von ≥ 95 % HT-Kupplungen aufweist.

6. Verfahren nach mindestens einem der Ansprüche 1 bis 5, **dadurch gekennzeichnet, dass** das Lösungsmittel ausgewählt ist aus Diethylether, Di-n-butylether, Di-n-propylether, Di-isopropylether, Ethern mit zwei unterschiedlichen Alkylgruppen, 1,2-Dimethyoxyethan oder t-Butylmethylether oder deren Mischungen oder Mischungen aus Toluol und einem oder mehreren der obigen Ether.

7. Verfahren nach Anspruch 6, **dadurch gekennzeichnet, dass** es sich bei dem Lösungsmittel um Diethylether handelt.

8. Verfahren nach mindestens einem der Ansprüche 2 bis 7, **dadurch gekennzeichnet, dass** die Konzentration des Thiophens in der Lösung in Schritt a) 40 bis 200 Gramm pro Liter beträgt.

9. Verfahren nach mindestens einem der Ansprüche 1 bis 8, **dadurch gekennzeichnet, dass** die Menge des Magnesiums > 1 bis 3 Mal die molare Menge des Thiophen-Ausgangsstoffes beträgt.

10. Verfahren nach Anspruch 9, **dadurch gekennzeichnet, dass** die Menge des Magnesiums 1,02 bis 1,20 Mal die molare Menge des Thiophen-Ausgangsstoffes beträgt.

11. Verfahren nach mindestens einem der Ansprüche 1 bis 10, **dadurch gekennzeichnet, dass** das nicht umgesetzte Magnesium vor Zugabe des Katalysators aus der Reaktionsmischung entfernt wird.

12. Verfahren nach mindestens einem der Ansprüche 1 bis 11, **dadurch gekennzeichnet, dass** es sich bei dem Katalysator um einen Ni(II)-Katalysator handelt.

13. Verfahren nach Anspruch 12, **dadurch gekennzeichnet, dass** der Katalysator aus Ni(dppp)Cl₂ (1,3-Diphenylphosphinopropan-nickel(ll)-chlorid) oder Ni(dppe)Cl₂ (1,2-Bis(diphenylphosphino)-ethan-nickel(II)-chlorid) ausgewählt ist.

14. Verfahren nach mindestens einem der Ansprüche 1 bis 13, **dadurch gekennzeichnet, dass** die Bildung des regiochemischen Grignard-Zwischenproduktes und die Polymerisation (Schritte a) und d)) bei einer Temperatur von Raumtemperatur bis Rückflusstemperatur durchgeführt werden.

15. Verfahren nach Anspruch 14, **dadurch gekennzeichnet, dass** die Bildung des regiochemischen Grignard-Zwischenproduktes und die Polymerisation (Schritte a) und d)) bei Rückflusstemperatur durchgeführt werden.

16. Verfahren nach mindestens einem der Ansprüche 1 bis 15, **dadurch gekennzeichnet, dass** das Polymer nach der Gewinnung aus der Reaktionsmischung gereinigt wird.

17. Verfahren nach mindestens einem der Ansprüche 1 bis 16, **dadurch gekennzeichnet, dass** das Polymer aus der Formel I 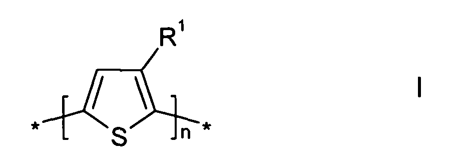 ausgewählt ist, worin n 10 bis 5000 bedeutet und R¹ eine Gruppe bedeutet, die unter den Bedingungen des Verfahrens nach einem der vorhergehenden oder folgenden Ansprüche nicht mit Magnesium reagiert.

18. Verfahren nach mindestens einem der Ansprüche 1 bis 17, **dadurch gekennzeichnet, dass** das 3-substituierte Thiophen aus der Formel II 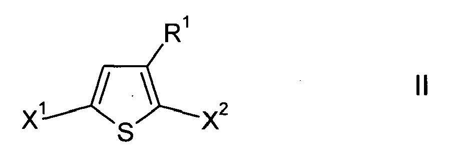 ausgewählt ist, worin R¹ die Bedeutung des Anspruchs 17 besitzt und X¹ und X² unabhängig voneinander Br oder Cl bedeuten.

19. Verfahren nach Anspruch 17 oder 18, **dadurch gekennzeichnet, dass** R¹ geradkettiges, verzweigtes oder cyclisches Alkyl mit 1 oder mehreren C-Atomen, das unsubstituiert oder ein- oder mehrfach durch F, Cl, Br, I oder CN substituiert sein kann,
wobei gegebenenfalls auch eine oder mehrere nicht benachbarte CH₂-Gruppen jeweils unabhängig voneinander so durch -O-, -S-, -NH-, -NR⁰-, -SiR⁰R⁰⁰-, -CO-, -COO-, -OCO-, -OCO-O-, -SO₂- -S-CO-, -CO-S-, -CY¹=CY²- oder -C≡C- ersetzt sind, dass O- und/oder S-Atome nicht direkt miteinander verknüpft sind, gegebenenfalls substituiertes Aryl oder Heteroaryl oder P-Sp bedeutet, wobei
R⁰ und R⁰⁰ unabhängig voneinander H oder Alkyl mit 1 bis 12 C-Atomen bedeuten,
Y¹ und Y² unabhängig voneinander H, F, Cl oder CN bedeuten,
P eine polymerisierbare oder reaktive Gruppe bedeutet, die gegebenenfalls geschützt ist, und
Sp eine Spacergruppe oder eine Einfachbindung bedeutet.

20. Verfahren nach Anspruch 19, **dadurch gekennzeichnet, dass** R¹ ausgewählt ist aus C₁-C₂₀-Alkyl, das gegebenenfalls mit einem oder mehreren Fluoratomen substituiert ist, C₁-C₂₀-Alkenyl, C₁-C₂₀-Alkinyl, C₁-C₂₀-Alkoxy, C₁-C₂₀-Thioalkyl, C₁-C₂₀-Siyl, C₁-C₂₀-Ester, C₁-C₂₀-Amino, C₁-C₂₀-Fluoralkyl.

21. Verfahren nach Anspruch 20, **dadurch gekennzeichnet, dass** R¹ ausgewählt ist aus geradkettigem oder verzweigtem Pentyl, Hexyl, Heptyl, Octyl, Nonyl, Decyl, Undecyl oder Dodecyl.

22. Verfahren nach Anspruch 21, **dadurch gekennzeichnet, dass** R¹ n-Hexyl bedeutet.

23. Verfahren nach mindestens einem der Ansprüche 17 bis 22, **dadurch gekennzeichnet, dass** X¹ und X² Br bedeuten.

24. Verfahren nach mindestens einem der Ansprüche 17 bis 23, **dadurch gekennzeichnet, dass** n eine ganze Zahl von 50 bis 1000 bedeutet.

25. Verfahren nach mindestens einem der Ansprüche 1 bis 24, **dadurch gekennzeichnet, dass** das Polymer aus der Formel I1 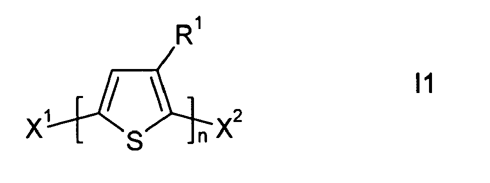 ausgewählt ist, worin n, R¹ X¹ und X² die Bedeutungen der Ansprüche 17 bis 24 besitzen.

26. Verfahren nach mindestens einem der Ansprüche 1 bis 25, **dadurch gekennzeichnet, dass** eine oder mehrere der endständigen Gruppen des Polymers chemisch modifiziert ("endverkappt") sind.

27. Verfahren nach Anspruch 26, **dadurch gekennzeichnet, dass** das Polymer nach der Endverkappung die Formel I2 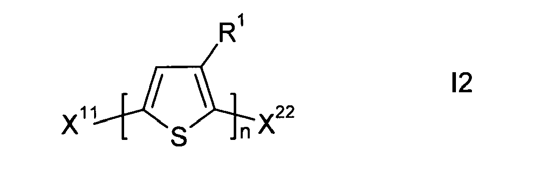 aufweist, worin n und R¹ die Bedeutungen der Ansprüche 17 bis 24 besitzen,
X¹¹ und X²² unabhängig voneinander H, Halogen, Sn(R⁰)₃ oder geradkettiges, verzweigtes oder cyclisches Alkyl mit 1 bis 20 C-Atomen, das unsubstituiert oder ein-oder mehrfach durch F, Cl, Br, I, -CN und/oder -OH substituiert sein kann, wobei gegebenenfalls auch eine oder mehrere nicht benachbarte CH₂-Gruppen jeweils unabhängig voneinander so durch -O-, -S-, -NH-, -NR⁰-, -SiR⁰R⁰⁰-, -CO-, -COO-, -OCO-, -OCO-O-, -S-CO-, -CO-S-, -CY¹=CY²- oder -C≡C-ersetzt sind, dass O- und/oder S-Atome nicht direkt miteinander verknüpft sind, gegebenenfalls substituiertes Aryl oder Heteroaryl, P-Sp- wie in Anspruch 19 definiert oder eine reaktive oder geschützte reaktive Gruppe bedeuten,
R⁰ und R⁰⁰ unabhängig voneinander H oder Alkyl mit 1 bis 12 C-Atomen bedeuten und
Y¹ und Y² unabhängig voneinander H, F, Cl oder CN bedeuten.

28. Verfahren nach Anspruch 27, **dadurch gekennzeichnet, dass** X¹¹ und X²² unabhängig voneinander Alkyl, welches gegebenenfalls mit einem oder mehreren Fluoratomen substituiert ist, Alkenyl, Alkinyl, Alkoxy, Thioalkyl, Silyl, Ester, Amino oder Fluoralkyl, wobei alle diese Gruppen geradkettig oder verzweigt sind und 1 bis 20 C-Atome aufweisen, oder gegebenenfalls substituiertes Aryl oder Heteroaryl oder P-Sp wie in Anspruch 19 definiert bedeuten.

29. Verfahren nach Anspruch 28, **dadurch gekennzeichnet, dass** X¹¹ und X²² geradkettiges oder verzweigtes Alkyl mit 1 bis 6 C-Atomen bedeuten.

30. Verfahren nach Anspruch 27, **dadurch gekennzeichnet, dass** X¹¹ und X²² aus Hydroxy-, Amin-, Aldehyd-, Stannat- oder Boronatgruppen ausgewählt sind.

31. Verfahren nach Anspruch 27 oder 30, **dadurch gekennzeichnet, dass** das Polymer der Formel 12 über die Endgruppe X¹¹ und/oder X²² mit dem gleichen oder einem unterschiedlichen Polymer der Formel 12 oder mit einem anderen Polymer zur Bildung eines Blockcopolymers weiter umgesetzt wird.

32. Polymer erhältlich durch ein Verfahren nach Anspruch 27, **dadurch gekennzeichnet, dass** es die Formel 12 aufweist, worin R¹ geradkettiges, verzweigtes oder cyclisches Alkyl mit 1 bis 20 C-Atomen bedeutet,
n 10 bis 5000 bedeutet,
X¹¹ und X²² aus Alkyl, welches gegebenenfalls mit einem oder mehreren Fluoratomen substituiert ist, Alkenyl, Alkinyl, Alkoxy, Thioalkyl, Silyl oder Fluoralkyl, wobei alle diese Gruppen geradkettig oder verzweigt sind und 1 bis 20 C-Atome aufweisen, gegebenenfalls substituiertem Aryl oder Heteroaryl oder P-Sp ausgewählt sind,
P aus CH₂=CH-COO-, CH₂=C(CH₃)-COO-, CH₂=CH-, CH₂=CH-O-, (CH₂=CH)₂CH-OCO-, (CH₂=CH)₂CH-O-, 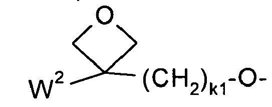 oder deren geschützten Derivaten ausgewählt ist,
W² H oder Alkyl mit 1 bis 5 C-Atomen, insbesondere Methyl, Ethyl oder n-Propyl bedeutet, k₁ 0 oder 1 bedeutet und Sp eine Spacergruppe oder eine Einfachbindung bedeutet.

33. Polymer nach Anspruch 32, **dadurch gekennzeichnet, dass** X¹¹ und X²² aus geradkettigem oder verzweigtem Alkyl mit 1 bis 12 C-Atomen ausgewählt sind.

34. Polymer nach Anspruch 32 oder 33, **dadurch gekennzeichnet, dass** R¹ aus geradkettigem oder verzweigtem Pentyl, Hexyl, Heptyl, Octyl, Nonyl, Decyl, Undecyl oder Dodecyl ausgewählt ist.

35. Verwendung eines Polymers nach mindestens einem der Ansprüche 32 bis 34 als Halbleiter- oder Ladungstransportmaterial, insbesondere in optischen, elektrooptischen oder elektronischen Vorrichtungen, wie beispielsweise in Feldeffekttransistoren (FET) als Bauteile integrierter Schaltungen, als Dünnschichttransistoren in Flachbildschirm-Anwendungen oder für RFID-Tags (Radio Frequency Identification), oder in Halbleiterbauteilen für Anwendungen mit organischen Leuchtdioden (organic light emitting diode - OLED) wie Elektrolumineszenzanzeigen oder Hintergrundbeleuchtungen von z.B. Flüssigkristallanzeigen (liquid crystal displays - LCD), für Photovoltaik- oder Sensorvorrichtungen, als Elektrodenmaterialien in Batterien, als Photoleiter, für elektrophotographische Anwendungen wie elektrophotographische Aufzeichnung oder zum Nachweis und zur Unterscheidung von DNA-Sequenzen.

36. Verwendung eines Polymers nach mindestens einem der Ansprüche 32 bis 34 als Elektrolumineszenzmaterial, in Photovoltaik- oder Sensorvorrichtungen, als Elektrodenmaterialien in Batterien, als Photoleiter, für elektrophotographische Anwendungen oder elektrophotographische Aufzeichnung.

37. Halbleiter- oder Ladungstransportmaterial, -bauteil oder -vorrichtung enthaltend ein oder mehrere Polymere nach mindestens einem der Ansprüche 32 bis 34.

38. Optische, elektrooptische oder elektronische Vorrichtung, FET, integrierte Schaltung (integrated circuit - IC), TFT oder OLED enthaltend ein halbleitendes oder Ladungstransportmaterial oder -bauteil oder eine halbleitende oder Ladungstransportvorrichtung nach Anspruch 37.

39. TFT oder TFT-Anordnung für Flachbildschirme, RFID-Tag, Elektrolumineszenzanzeige oder Hintergrundbeleuchtung enthaltend ein halbleitendes oder Ladungstransportmaterial oder -bauteil oder eine halbleitende oder Ladungstransportvorrichtung oder einen FET, eine IC, einen TFT oder eine OLED nach Anspruch 37 oder 38.

40. Sicherheitsmarkierung oder -vorrichtung enthaltend einen FET oder ein RFID-Tag Verfahren nach Anspruch 39.

41. Polymer nach mindestens einem der Ansprüche 32 bis 34, welches oxidativ oder reduktiv dotiert ist, um leitende Ionenspezies zu bilden.

42. Ladungsinjektionsschicht, Planarisierungsschicht, antistatische Folie oder leitendes Substrat oder leitende Struktur für Elektronikanwendungen oder Flachbildschirme, enthaltend ein Polymer nach Anspruch 41.

## Revendications

1. Procédé de préparation d'un poly(thiophène 3-substitué) régio-régulier en fournissant un thiophène 3-substitué comportant des groupes chloro et/ou bromo aux positions 2 et 5, en faisant réagir ledit thiophène avec du magnésium dans un solvant choisi parmi le groupe constitué par des éthers linéaires, leurs mélanges et des mélanges de toluène avec un ou plusieurs éthers linéaires, et en polymérisant le produit intermédiaire de Grignard régiochimique formé ou le mélange de produits intermédiaires de Grignard régiochimiques formés en ajoutant un catalyseur approprié.

2. Procédé selon la revendication 1, en
a) dissolvant le thiophène 3-substitué dans un solvant ou un mélange de solvants choisis parmi le groupe constitué par des éthers linéaires, leurs mélanges et des mélanges de toluène avec un ou plusieurs éthers linéaires, en
b) ajoutant du magnésium selon une quantité au moins molaire du thiophène à la solution ou en ajoutant la solution audit magnésium, dans lequel ledit magnésium réagit avec ledit thiophène pour former un produit intermédiaire de Grignard régiochimique ou un mélange de produits intermédiaires de Grignard régiochimiques,
c) en option, en enlevant le magnésium n'ayant pas réagi du mélange de réaction, en
d) ajoutant un catalyseur au mélange de réaction ou en ajoutant le mélange de réaction à un catalyseur et en option, en agitant le mélange, pour former un polymère, et en
e) récupérant le polymère à partir du mélange.

3. Procédé selon la revendication 1 ou 2, **caractérisé en ce que** le substituant à la position 3 du thiophène est un groupe organique qui, lorsqu'il est un alkyle en chaîne droite ou ramifié non substitué et non modifié, comporte 5 atomes de C ou plus.

4. Procédé selon au moins l'une des revendications 1 à 3, **caractérisé en ce que** le thiophène 3-substitué est un 2,2-dibromothiophène 3-substitué.

5. Procédé selon au moins l'une des revendications 1 à 4, **caractérisé en ce que** le poly(thiophène 3-substitué) présente une régiorégularité de ≥ 95% de couplages HT.

6. Procédé selon au moins l'une des revendications 1 à 5, **caractérisé en ce que** le solvant est choisi parmi diéthyléther, di-n-butyléther, di-n-propyléther, di-isopropyléther, des éthers comportant deux groupes alkyle différents, 1,2-diméthyoxyéthane ou t-butylméthyléther, ou leurs mélanges, ou des mélanges de toluène avec un ou plusieurs des éthers mentionnés ci avant.

7. Procédé selon la revendication 6, **caractérisé en ce que** le solvant est du diéthyléther.

8. Procédé selon au moins l'une des revendications 2 à 7, **caractérisé en ce que** la concentration du thiophène dans la solution au niveau de l'étape a) va de 40 à 200 g par litre.

9. Procédé selon au moins l'une des revendications 1 à 8, **caractérisé en ce que** la quantité du magnésium va de > 1 à 3 fois la quantité molaire d'educt thiophène.

10. Procédé selon la revendication 9, **caractérisé en ce que** la quantité du magnésium va de 1,02 à 1,20 fois la quantité molaire d'educt thiophène.

11. Procédé selon au moins l'une des revendications 1 à 10, **caractérisé en ce que** le magnésium n'ayant pas réagi est enlevé du mélange de réaction avant ajout du catalyseur.

12. Procédé selon au moins l'une des revendications 1 à 11, **caractérisé en ce que** le catalyseur est un catalyseur Ni(II).

13. Procédé selon la revendication 12, **caractérisé en ce que** le catalyseur est choisi parmi Ni(dppp)Cl₂ (chlorure de 1,3-diphénylphosphinopropane nickel(II)) et Ni(dppe)Cl₂ (chlorure de 1,2-bis(diphénylphosphino)éthane nickel(II)).

14. Procédé selon au moins l'une des revendications 1 à 13, **caractérisé en ce que** la formation du produit intermédiaire de Grignard régiochimique et la polymérisation (étapes a) et d)) sont mises en oeuvre à une température qui va de la température ambiante à la température de reflux.

15. Procédé selon la revendication 14, **caractérisé en ce que** la formation du produit intermédiaire de Grignard régiochimique et la polymérisation (étapes a) et d)) sont mises en oeuvre à la température de reflux.

16. Procédé selon au moins l'une des revendications 1 à 15, **caractérisé en ce que** le polymère est purifié après avoir été récupéré à partir du mélange de réaction.

17. Procédé selon au moins l'une des revendications 1 à 16, **caractérisé en ce que** le polymère est choisi à partir de la formule I 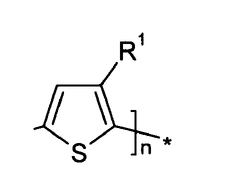 dans laquelle n va de 10 à 5000 et R¹ est un groupe qui ne réagit pas avec le magnésium sous les conditions du procédé selon l'une quelconque des revendications précédentes ou des revendications qui suivent.

18. Procédé selon au moins l'une des revendications 1 à 17, **caractérisé en ce que** le thiophène 3-substitué est choisi à partir de la formule II 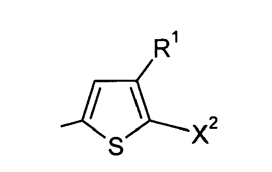 dans laquelle R¹ présente la signification de la revendication 17, et X¹ et X² sont, indépendamment l'un de l'autre, Br ou Cl.

19. Procédé selon la revendication 17 ou 18, **caractérisé en ce que** R¹ est alkyle en chaîne droite, ramifié ou cyclique comportant 1 atome de C ou plus, lequel peut être non substitué, mono- ou polysubstitué par F, CI, Br, I ou CN, étant entendu qu'il est également possible qu'un ou que plusieurs groupes CH₂ non adjacents soient remplacés, dans chaque cas indépendamment les uns des autres, par -O-, -S-, -NH-, -NR⁰-, -SiR⁰R⁰⁰-, -CO-, -COO-, -OCO-, -OCO-O-, -SO₂-, S-CO-, -CO-S-, -CY¹=CY²- ou -C≡C- de telle sorte que des atomes de O et /ou de S ne soient pas liés directement les uns aux autres, aryle ou hétéroaryle, en option substitué, ou P-Sp-,
R⁰ et R⁰⁰ étant, indépendamment l'un de l'autre, H ou alkyle avec de 1 à 12 atomes de C,
Y¹ et Y² étant, indépendamment l'un de l'autre, H, F, Cl ou CN,
P étant un groupe polymérisable ou réactif qui est en option protégé, et
Sp étant un groupe d'espaceur ou une liaison simple.

20. Procédé selon la revendication 19, **caractérisé en ce que** R¹ est choisi parmi C₁-C₂₀-alkyle qui est en option substitué par un ou plusieurs atomes de fluor, C₁-C₂₀-alkényle, C₁-C₂₀-alkynyle, C₁-C₂₀-alcoxy, C₁-C₂₀-thioalkyle, C₁-C₂₀-Silyle, C₁-C₂₀-ester, C₁-C₂₀-amino, C₁-C₂₀-fluoroalkyle.

21. Procédé selon la revendication 20, **caractérisé en ce que** R¹ est choisi parmi pentyle, hexyle, heptyle, octyle, nonyle, décyle, undécyle ou dodécyle en chaîne droite ou ramifié.

22. Procédé selon la revendication 21, **caractérisé en ce que** R¹ est n-hexyle.

23. Procédé selon au moins l'une des revendications 17 à 22, **caractérisé en ce que** X¹ et X² sont Br.

24. Procédé selon au moins l'une des revendications 17 à 23, **caractérisé en ce que** n est un entier de 50 à 1000.

25. Procédé selon au moins l'une des revendications 1 à 24, **caractérisé en ce que** le polymère est choisi à partir de la formule 11 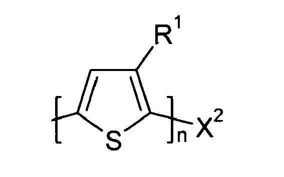 dans laquelle n, R¹, X¹ et X² présentent les significations des revendications 17 à 24.

26. Procédé selon au moins l'une des revendications 1 à 25, **caractérisé en ce qu'**un ou plusieurs des groupes terminaux du polymère sont modifiés chimiquement ("sont capuchonnés en extrémité").

27. Procédé selon la revendication 26, **caractérisé en ce que** le polymère après capuchonnage d'extrémité est de formule 12 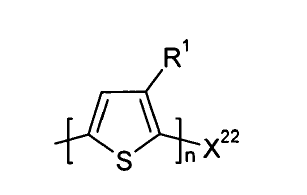 dans laquelle n et R¹ présentent les significations des revendications 17 à 24,
X¹¹ et X²² sont, indépendamment l'un de l'autre, H, halogène, Sn(R⁰)₃ ou alkyle en chaîne droite, ramifié ou cyclique comportant de 1 à 20 atomes de C, lequel peut être non substitué, mono- ou polysubstitué par F, CI, Br, 1, -CN et/ou -OH, étant entendu qu'il est également possible qu'un ou que plusieurs groupes CH₂ non adjacents soient remplacés, dans chaque cas indépendamment les uns des autres, par -O-, -S-, -NH-, -NR⁰-, -SiR⁰R⁰⁰-, -CO-, -COO-, -OCO-, -OCO-O-, -S-CO-, -CO-S-, -CY¹=CY²- ou -C≡C- de telle sorte que des atomes de O et/ou de S ne soient pas liés directement les uns aux autres, aryle ou hétéroaryle, en option substitué, P-Sp- comme défini selon la revendication 19, ou un groupe réactif ou réactif protégé,
R⁰ et R⁰⁰ sont, indépendamment l'un de l'autre, H ou alkyle comportant de 1 à 12 atomes de C, et
Y¹ et Y² sont, indépendamment l'un de l'autre, H, F, Cl ou CN.

28. Procédé selon la revendication 27, **caractérisé en ce que** X¹¹ et X²² sont, indépendamment l'un de l'autre, alkyle qui est en option substitué par un ou plusieurs atomes de fluor, alkényle, alkynyle, alcoxy, thioalkyle, silyle, ester, amino ou fluoroalkyle, tous ces groupes étant en chaîne droite ou ramifiés et comportant de 1 à 20 atomes de C, ou aryle ou hétéroaryle en option substitué, ou P-Sp- comme défini selon la revendication 19.

29. Procédé selon la revendication 28, **caractérisé en ce que** X¹¹ et X²² représentent alkyle en chaîne droite ou ramifié avec de 1 à 6 atomes de C.

30. Procédé selon la revendication 27, **caractérisé en ce que** X¹¹ et X²² sont choisis parmi des groupes hydroxy, amine, aldéhyde, stannate ou boronate.

31. Procédé selon la revendication 27 ou 30, **caractérisé en ce que** le polymère de formule 12 est en outre amené à réagir via un groupe d'extrémité X¹¹ et/ou X²² avec le même polymère de formule 12 ou un polymère différent, ou avec un autre polymère, pour former un copolymère bloc.

32. Polymère pouvant être obtenu au moyen d'un procédé selon la revendication 27, **caractérisé en ce qu'**il est de formule 12, dans lequel
R¹ est alkyle en chaîne droite, ramifie ou cyclique comportant de 1 à 20 atomes de C,
n va de 10 à 5000,
X¹¹ et X²² sont choisis parmi alkyle qui est en option substitué par un ou plusieurs atomes de fluor, alkényle, alkynyle, alcoxy, thioalkyle, silyle ou fluoroalkyle, tous ces groupes étant en chaîne droite ou ramifiés et comportant de 1 à 20 atomes de C, aryle ou hétéroaryle, en option substitué, ou P-Sp,
P est choisi parmi CH₂=CH-COO-, CH₂=C(CH₃)-COO-, CH₂=CH-, CH₂=CH-O-, (CH₂=CH)₂CH-OCO-, (CH₂=CH)₂CH-O-, 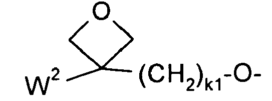 ou leurs dérivés protégés,
W² est H ou alkyle comportant de 1 à 5 atomes de C, en particulier méthyle, éthyle ou n-propyle,
k₁ est 0 ou 1, et
Sp est un groupe d'espaceur ou une liaison simple.

33. Polymère selon la revendication 32, **caractérisé en ce que** X¹¹ et X²² sont choisis parmi alkyle en chaîne droite ou ramifié comportant de 1 à 12 atomes de C.

34. Polymère selon la revendication 32 ou 33, **caractérisé en ce que** R¹ est choisi parmi pentyle, hexyle, heptyle, octyle, nonyle, décyle, undécyle ou dodécyle en chaîne droite ou ramifié.

35. Utilisation d'un polymère selon au moins l'une des revendications 32 à 34 en tant que semiconducteur ou matériau de transport de charges, en particulier dans des dispositifs optiques, électro-optiques ou électroniques tels que par exemple dans des transistors à effet de champ (FET) en tant que composants de circuit intégré, en tant que transistors à film mince dans des applications d'affichage à écran plat ou pour des étiquettes d'identification radiofréquence (RFID), ou dans des composants de semiconduction pour des applications de diodes émettrices de lumière organiques (OLED) telles que des affichages électroluminescents ou des éclairages arrière par exemple d'affichages à cristaux liquides (LCD), pour des dispositifs photovoltaïques ou de capteur, en tant que matériaux d'électrode dans des accumulateurs, en tant que photoconducteurs, pour des applications électrophotographiques telles qu'un enregistrement électrophotographique ou pour détecter et discriminer des séquences ADN.

36. Utilisation d'un polymère selon au moins l'une des revendications 32 à 34 en tant que matériau électroluminescent, dans des dispositifs photovoltaïques ou de capteur, en tant que matériaux d'électrode dans des accumulateurs, en tant que photoconducteurs, pour des applications électrophotographiques ou pour un enregistrement électrophotographique.

37. Matériau semiconducteur ou de transport de charges, composant ou dispositif comprenant un ou plusieurs polymères selon au moins l'une des revendications 32 à 34.

38. Dispositif optique, électro-optique ou électronique, FET, circuit intégré (lC), TFT ou OLED comprenant un matériau de semiconduction ou de transport de charges, un composant ou un dispositif selon la revendication 37.

39. TFT ou réseau de TFT pour des affichages à écran plat, une étiquette d'identification radiofréquence (RFID), un affichage électroluminescent ou un éclairage arrière comprenant un matériau de semiconduction ou de transport de charges, un composant ou un dispositif ou un FET, un IC, un TFT ou une OLED selon la revendication 37 ou 38.

40. Marquage ou dispositif de sécurité comprenant un FET ou une étiquette RFID selon la revendication 39.

41. Polymère selon au moins l'une des revendications 32 à 34, lequel est dopé par oxydation ou par réduction pour former des espèces ioniques conductrices.

42. Couche d'injection de charges, couche de planarisation, film antistatique ou substrat ou motif de conduction pour des applications électroniques ou des affichages à écran plat, comprenant un polymère selon la revendication 41.
